(19) **Europäisches Patentamt**
**European Patent Office**
**Office européen des brevets**

(11) **EP 3 121 740 A1**

(12) **EUROPEAN PATENT APPLICATION**
published in accordance with Art. 153(4) EPC

(43) Date of publication:
**25.01.2017 Bulletin 2017/04**

(21) Application number: **14892221.4**

(22) Date of filing: **03.06.2014**

(51) Int Cl.:
**G06F 17/50** (2006.01)

(86) International application number:
**PCT/CN2014/079075**

(87) International publication number:
**WO 2015/180196 (03.12.2015 Gazette 2015/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.05.2014 CN 201410228903**

(71) Applicant: **China Academy of Space Technology Beijing 100094 (CN)**

(72) Inventors:
• **ZHOU, Zhicheng**
**Beijing 100094 (CN)**

• **CHEN, Yujun**
**Beijing 100094 (CN)**
• **WANG, Min**
**Beijing 100094 (CN)**
• **YUAN, Jungang**
**Beijing 100094 (CN)**
• **SUN, Zhiguo**
**Beijing 100094 (CN)**
• **LIANG, Zongchuang**
**Beijing 100094 (CN)**

(74) Representative: **Witte, Weller & Partner Patentanwälte mbB Postfach 10 54 62 70047 Stuttgart (DE)**

(54) **MULTIDISCIPLINARY OPTIMIZATION-BASED SYSTEM FOR DETERMINING SATELLITE OVERALL PLAN, AND IMPLEMENTATION METHOD**

(57) There is provided a system for determining a satellite overall scheme based on multidisciplinary optimization and an implementation method thereof according to the disclosure. The system includes a satellite overall technical index extracting module, a satellite overall technical index allocating module, a satellite subsystem technical index forming module, a satellite system design discipline decomposing module, a design structure matrix generating module, a satellite system discipline analyzing and modeling module, a satellite system optimizing and modeling module, a model simplification module, a two-level collaborative optimizing and modeling module, a collaborative optimizing and solving module, a satellite overall technology index database, a model baseline design database, a design parameter base, and a model library, and a satellite overall scheme parameter outputting module. In the method, the multidisciplinary design optimization of the overall solution of the satellite is achieved by extracting system indexes, decomposing disciplines and design tasks, design discipline analyzing and modeling, structuring a design structure matrix, satellite overall scheme multidisciplinary design optimization representation , model simplification, two-level collaborative optimization modeling and solving.

Fig .1

**Description**

**CROSS REFERENCE TO RELATED APPLICATIONS**

The present application claims the priority to Chinese Patent Application No. 201410228903.5, titled "SYSTEM FOR DETERMINING SATELLITE OVERALL SCHEME BASED ON MULTIDISCIPLINARY OPTIMIZATION, AND IMPLEMENTATION METHOD THEREOF", filed on May 27, 2014 with the State Intellectual Property Office of China, which is incorporated herein by reference in its entirety.

**FIELD**

The disclosure relates to a system for determining a satellite overall scheme based on multidisciplinary optimization, and an implementation method thereof, and belongs to the technical field of aircraft overall design optimization.

**BACKGROUND**

Satellite overall design relates to satellite body, engineering systems for delivering, launching, measurement and control, and application, includes traditional disciplines such as payload, orbit, control, propulsion, structure, configuration, power supply, thermal control, data management, and measurement and control, and non-traditional disciplines such as performance, manufacture, costs, and reliability, and is a complicated engineering system including multiple disciplines mutually coupled.

Currently, an overall design scheme is formed by performing repeated manual coordination on subsystem schemes independently designed through task decomposition based on tasks required by a user and conventional technology. Following problems may occur. It is difficult to ensure sufficient coordination between the subsystems and reasonable allocation of design margin by manually decomposing the coupling between subsystems. Designs of the subsystems are difficult to be coordinated and comprehensively assessed, and designs in different subjects may collide, which lead to uncontrollable design costs. A serial operation mode of various subsystems leads to low operating efficiency. Designs of the subsystems are heavily dependent on experiences of designers. Homology of models and data are difficult to be ensured in a case that the designed coupling information of the subsystems are interacted in a manual way. Transmission based on networking or parameterization is difficult to be performed due to poor model design and analysis, which causes a lot of repetitive work and low overall design efficiency. A large amount of engineering data not effectively managed makes existing history data difficult to be fully utilized.

In addition, a complicated communication satellite has numerous paths of transponders, a large-scale antenna, a heavy payload, and strict payload indexes, and the payload and a platform of the satellite are considered in combination, which results in difficulty in the overall scheme design. Based on manual decomposition and coordination, it is difficult to achieve integral optimization of comprehensive performance indexes of the system, and an overall design of a complicated and giant new spacecraft. Thus an upgraded design mode is highly required.

**SUMMARY**

To address the above problems, a system for determining a satellite overall scheme based on multidisciplinary optimization and an implementation method thereof, are provided in this disclosure. A satellite overall design-oriented general project implementation system and method is established to achieve quick generation and design optimization of the satellite overall scheme.

Technical solutions according to embodiments of the disclosure are as follows.

A system for determining a satellite overall scheme based on multidisciplinary optimization includes: a satellite design parameter input system, a FPGA system, a central database storage and management system, and a satellite scheme parameter outputting module; wherein the satellite design parameter input system comprises a satellite overall technical index extracting module, and a satellite overall technical index allocating module; the FPGA system comprises a satellite subsystem technical index forming module, a satellite system design discipline decomposing module, a design structure matrix generating module, a satellite system discipline analyzing and modeling module, a satellite system optimizing and modeling module, a model simplification module, a two-level collaborative optimizing and modeling module, and a collaborative optimizing and solving module; wherein the central database storage and management system comprises a satellite overall technology index database, a model baseline design database, a design parameter base, and a model library; and the central database storage and management system comprises a satellite overall technical index database, a model baseline design database, a design parameter library, and a model library; wherein the satellite overall technical index extracting module is configured to form an overall technical index set by parameterizing functional indexes and non-functional indexes of a satellite system as required, and store the overall technical index set into the satellite overall technical index database; wherein the functional indexes are technical indexes indicating system performances of the satellite, and the non-functional indexes are supplementary technical indexes other than the functional indexes of the satellite;

the satellite overall technical index allocating module is configured to allocate the overall technical index set in the satellite overall technical index database as input for the modules in the FPGA system;

the satellite subsystem technical index forming module is configured to receive the overall technical index set transmitted by the satellite overall technical index allocating module, determine technical requirements of subsystems of the satellite according to the overall technical index set, and transmit the technical requirements to the satellite system design discipline decomposing module;

the satellite system design discipline decomposing module is configured to decompose a satellite overall design plan into design disciplines according to the overall technical index set transmitted by the satellite overall technical index allocating module, determine calculation tasks of each design discipline, determine input parameters and output parameters for each design discipline, and store the input parameters and output parameters for each design discipline into the design parameter library respectively; where the design disciplines are calculation modules for performing functions of the subsystems or for analyzing system performances;

the design structure matrix generating module is configured to generate a satellite overall design structure matrix based on the decomposed design disciplines in the design parameter library and the input parameters and output parameters, and transmit the design structure matrix to the satellite system optimizing and modeling module; wherein the generating a design structure matrix comprises: performing intersection calculation on the input parameters and output parameters of the design disciplines, generating a design discipline correlation matrix table according to a result of the intersection calculation performed on the input parameters and output parameters of the design disciplines, and generating a design discipline structure matrix;

the satellite system optimizing and modeling module is configured to determine system technical indexes most concerned in the satellite overall technical index database as optimization objects, determine output parameters corresponding to the satellite system design boundary conditions as constraint variables, acquire input parameters corresponding to the optimization objects from the design parameter library, in conjunction with design parameters provided by the model baseline design database, select variable input parameters from the input parameters as design variables, determine design disciplines to be optimized according to the optimization objects, the constraint variables and the design variables, obtain an intersection of the design structure matrix and the design disciplines to be optimized, as a satellite overall optimization-oriented design structure matrix, and transmit the satellite overall optimization-oriented design structure matrix to the model simplification module; wherein the determining design disciplines to be optimized comprises: obtaining an intersection of the optimization objects, the constraint variables and the design variables, as the design disciplines to be optimized;

the satellite system discipline analyzing and modeling module is configured to establish calculation models corresponding to the index requirements of each subsystem of the satellite according to the decomposed satellite design disciplines and the input parameters and output parameters stored in the design parameter library, transmit calculation models of the design disciplines to be simplified to the model simplification module, and directly store analysis models of the design disciplines not to be simplified to the model library;

the model simplification module is configured to calculate sensitivity coefficients of the optimization objects and the constraint variables with respect to the design variables according to satellite system global sensitivity equations or system sensitivity analysis, remove design variables with sensitivity coefficients smaller than or equal to a determined value, establish regression or interpolation fitting models of reserved design variables and the output parameters of the optimization design disciplines corresponding to the regression or interpolation fitting models according to an experimental design method and an approximation model method to simplify the discipline calculation models transmitted by the satellite system discipline analyzing and modeling module, store the simplified regression or interpolation fitting models of the design disciplines into the model library, and name the regression or interpolation fitting models as approximation models; decouple design disciplines with sensitivity coefficients smaller than the determined value in the optimization design structure matrix, and unite design disciplines in a serial relation in the optimization design structure matrix, to simplify the optimization design structure matrix;

the two-level collaborative optimizing and modeling module is configured to decompose the design disciplines in the simplified optimization design structure matrix output by the model simplification module into parent disciplines and child disciplines, decouple the parent disciplines from the child disciplines and decouple the child disciplines according to consistency constraint equations between the disciplines at the two levels, wherein the consistency constraint equations are constructed by shared design variables and coupled state variables, allocate the constraint variables and design variables output by the satellite optimizing and modeling module to the parent disciplines and the child disciplines, establish parent discipline optimization models according to parent discipline optimization objects, constraint variables corresponding to the consistency constraint equations, and the parent discipline design variables constructed by shared design variables and coupled state variables, take the parent consistency constraints as child discipline optimization objects and establish child discipline optimization models based on child discipline optimization objects, child discipline constraint variables, and the child discipline design variables; wherein the parent disciplines are disciplines in least correlation with other disciplines, and the child disciplines are disciplines other than the parent disciplines in the optimization structure matrix;

the collaborative optimizing and solving module is configured to obtain optimized design variables by performing iteration solving on the parent optimization models and the child optimization models obtained by the two-level collaborative optimizing and modeling module, and the calculation models of the design disciplines in the model library;

the satellite scheme parameter outputting module is configured to report an overall scheme generated from a satellite overall design scheme parameter set based on the optimized result output by the collaborative optimizing and solving module;

the satellite overall technical index database is configured to store the overall technical index set output by the satellite overall technical index extracting module;

the model baseline design database is configured to store design parameters of an existing historical type satellite, and provide the design parameters of the existing historical type satellite to the satellite system optimizing and modeling module to determine optimization design variables;

the design parameter library is configured to store the design disciplines decomposed by the satellite system design discipline decomposing module; and

the module library is configured to store the design discipline calculation models established by the satellite system discipline analyzing and modeling module, and the design discipline approximation models simplified and output by the model simplification module.

Optionally, the technical indexes indicating system performances comprise at least: coverage, direction, and communication capacity, wherein the supplementary technical indexes comprise at least: weight of the whole satellite, power, total heat consumption, outline envelop size, center of mass, basic structural frequency, lifetime, costs and reliability.

Optionally, the design disciplines comprise at least models of payload, orbit, control, propulsion, structure, configuration, power supply, thermal control, data management, measurement and control, reliability, and costs.

Optionally, the discipline correlation matrix table is generated by: defining generated input parameters and output parameters of each discipline as string vectors, performing an analysis of correlation between the design disciplines by performing intersection calculation on the string vectors, and automatically extracting a result of vector calculation, denoting the result as 1 if the result is not null, wherein is the 1 indicates there is a correlation, otherwise denoting the result as 0.

Optionally, the intersection calculation performed on the input parameters and output parameters of design disciplines comprises intersection calculation performed on input parameter sets, and intersection calculation performed on input parameter sets and output parameter sets, intersections of input parameter sets are stored as shared design variables, and intersections of input parameter sets and output parameter sets are stored as coupled state variables.

A method for implementing the system for determining a satellite overall scheme includes:

(1) forming an overall technical index set by parameterizing functional indexes and non-functional indexes of a satellite system;

(2) determining technical requirements of subsystems of the satellite according to the overall technical index set formed in step (1), decomposing a satellite overall design plan into design disciplines according to technical requirements of subsystems of the satellite, determining calculation tasks of each design discipline according to the overall technical index set, and determining input parameters and output parameters for each design discipline;

(3) generating a satellite overall design structure matrix based on the decomposed design disciplines in step (2); wherein the generating a design structure matrix comprises: performing intersection calculation on the input parameters and output parameters of the design disciplines, generating a design discipline correlation matrix table according to a result of the intersection calculation performed on the input parameters and output parameters of the design disciplines, and generating a design discipline structure matrix; wherein the intersection calculation performed on the input parameters and output parameters of design disciplines comprises intersection calculation performed on input parameter sets, and intersection calculation performed on input parameter sets and output parameter sets, intersections of input parameter sets are shared design variables, and intersections of input parameter sets and output parameter sets are coupled state variables.

(4) establishing functional indexes and non-functional indexes of the satellite system, and calculation models corresponding to each subsystem of the satellite, based on the decomposed satellite design disciplines obtained in step (2) and the input parameters and output parameters;

(5) determining system technical indexes most concerned in the satellite overall technical index database as optimization objects; determining output parameters corresponding to the satellite system design boundary conditions as constraint variables; determining input disciplines and parameters corresponding to the optimization objects from the design parameter library; selecting, according to baseline type design parameters, variable input parameters from the input parameters as design variables; determining design disciplines to be optimized according to the optimization objects, the constraint variables and the design variables; and obtaining an intersection of the design structure matrix obtained in step (3) and the design disciplines to be optimized, as a satellite overall optimization-oriented design structure matrix;

(6) calculating sensitivity coefficients of the optimization objects and the constraint variables with respect to the design variables obtained in step (5) according to system global sensitivity equations, removing design variables with sensitivity coefficients smaller than or equal to a determined value; establishing regression or interpolation fitting models of reserved design variables and the output parameters of the optimization design disciplines corresponding to the regression or interpolation fitting models according to an experimental design method and an approximation model method to simplify the discipline calculation models in step (4); decoupling disciplines with sensitivity coefficients smaller than the determined value in the optimization design structure matrix, and uniting design disciplines in a serial relation in the optimization design structure matrix, to simplify the optimization design structure matrix obtained in step (5);

(7) decomposing the design disciplines in the optimization design structure matrix simplified in step (6) into parent disciplines and child disciplines; decoupling the parent disciplines from the child disciplines and decoupling the child disciplines according to consistency constraint equations between the disciplines at the two levels, wherein the consistency constraint equations are constructed by shared design variables and coupled state variables; allocating the constraint variables and design variables obtained in step (5) to the parent disciplines and the child disciplines; establishing parent discipline optimization models according to parent discipline optimization objects, constraint variables corresponding to the consistency constraint equations, and the parent discipline design variables constructed by shared design variables and coupled state variables, taking the parent consistency constraints as child discipline optimization objects and establishing child discipline optimization models based on child discipline optimization objects, child discipline constraint variables, and the child discipline design variables; wherein the parent disciplines are disciplines in least correlation with other disciplines, and the child disciplines are disciplines other than the parent disciplines in the optimization structure matrix;

(8) obtaining optimization results by performing iteration solving on the parent optimization models and the child optimization models obtained in step (7), the simplified models of the design disciplines obtained in step (6), and the not simplified models of the design disciplines obtained in step (4); and

(9) reporting an overall scheme generated from a satellite overall design scheme parameter set based on the optimization results output by step (8).

Optionally, the method for implementing the system for determining a satellite overall scheme is applied in scheme design and optimization for a low earth orbit communication satellite, a high earth orbit communication satellite or a constellation system.

Compared with the technology, the system and the implementation method thereof according to the disclosure may have following advantages.

(1) In the disclosure, a general system for determining a satellite overall scheme is established based on a multidisciplinary optimization method and a modular concept. By fully considering the existing overall design mode and closely meeting practical engineering requirements, the system and the implementation method thereof according to the disclosure are simple in structure implementation, widely applicable in rapid design and multidisciplinary optimization of a GEO satellite overall scheme, thereby comprehensively optimizing performances of the satellite system, optimizing types and parameters of the scheme, and greatly improving a level of the satellite overall design.

(2) An advanced design tool is provided for satellite overall design according to the disclosure, which shortens the development cycle and development costs, and improves the overall satellite design level and design efficiency, where the design efficiency may be about 50%.

(3) According to the satellite overall design based on the multidisciplinary optimization method provided in the disclosure, full collaboration of coupled design elements of various subsystems or design disciplines is achieved, and thus, design margins of the subsystems and design disciplines can be reasonably and scientifically allocated.

(4) With the new satellite overall design mode based on models and the multidisciplinary optimization method according to the disclosure, automation in the satellite overall design is greatly improved, and labor cost is saves by more than 80%.

(5) With the satellite overall design based on the multidisciplinary optimization method according to the disclosure, data interaction between design disciplines is standardized, and thus, standardization and scientization of the content and process of the satellite overall design are further promoted.

(6) In the disclosure, tasks, data and models of satellite overall design are all managed through central databases, data homology for designs of subsystems or disciplines is achieved, and historical type data are fully used.

BRIEF DESCRIPTION OF THE DRAWINGS

Figure 1 is a structural diagram of a system for determining a satellite overall scheme based on multidisciplinary optimization according to the disclosure;

Figure 2 is a schematic diagram of configuration of system indexes of a mobile communication satellite according to the disclosure;

Figure 3 is a schematic diagram of a combination of disciplines related to the overall design of a mobile communication satellite according to the disclosure;

Figure 4 is a schematic diagram of a structure matrix of the overall design of a mobile communication satellite according to the disclosure;

Figure 5 shows design disciplines related to an overall optimization design of a mobile communication satellite according to the disclosure;

Figure 6 shows an optimization design structure matrix formed by disciplines included in optimization design of a mobile communication satellite according to the disclosure;

Figure 7 shows a spherical trigonometry relationship for an orbit of a mobile communication satellite according to the disclosure;

Figure 8 is a schematic diagram showing that a central boresight and coverage of a multi-beam antenna of a mobile communication satellite on a small inclination orbit according to the disclosure;

Figure 9 is a schematic diagram of a propulsion vector of a mobile communication satellite in a coordinate system according to the disclosure;

Figure 10 is a schematic diagram of a principle for determining a relation between an edge sub-beam and a boundary of a service area of a mobile communication satellite according to the disclosure;

Figure 11 shows a simplified optimization design structure matrix of a mobile communication satellite according to the disclosure;

Figure 12 is a schematic diagram of a principle for optimizing and solving structure parameters based on proxy models of a mobile communication satellite according to the disclosure;

Figure 13 is a block diagram of a two-level collaborative optimization and solution of a mobile communication satellite according the disclosure; and

Figure 14 is a flow chart of a method for determining a satellite overall scheme based on multidisciplinary optimization according to the disclosure.

## DETAILED DESCRIPTION

Embodiments of the disclosure are further described as follows in conjunction with drawings.

A communication satellite system mainly includes three parts: an orbit, a payload and a satellite platform. The orbit part is mainly configured for designing a scheme of a satellite orbit. The payload part is mainly configured for designing satellite performance meeting user indexes, and includes two subsystems, i.e., an antenna and a transponder. And the satellite platform part is configured to support function implementation of a payload, and includes a power supply and distribution subsystem, a thermal control subsystem, a control subsystem, a propulsion subsystem, a structure subsystem, a data management subsystem (data management unit DMU) and a measurement and control subsystem.

Main functions of the subsystems of the satellite platform are briefly described as follows.

The power supply and distribution subsystem is a subsystem of the satellite configured to generate, store, convert, adjust and allocate electric energy, and supplies power to the subsystems of the payload and the platform of the satellite.

The thermal control subsystem is configured to use, under a given condition, various possible thermal control methods to control thermal exchange between inside and outside of the satellite, to make technical indexes such as temperatures, temperature differences and temperature stabilities of the satellite and apparatuses thereof meet overall technical requirements.

The control subsystem is configured to control the attitude and orbit of the satellite, and implement attitude direction, fixed-point orbital injection, and maintenance of orbital position.

The propulsion subsystem is configured to provide a control force and a torque for orbital maneuver, orbital maintenance, and attitude direction control of the satellite.

The structure subsystem is a general name of parts and accessories for providing support to the satellite and apparatuses of the satellite, or for supporting and transferring the payload, and the parts and accessories keep stable stiffness and size.

The data management subsystem is configured to store various programs, collect and process data, and coordinate and manage operations of the subsystems.

The measurement and control subsystem is a general name for three subdecompositions of telemetry, remote control and tracking orbit measurement.

In an integrated design of the satellite system, multiple subsystems of the satellite are involved, multiple design disciplines are covered, and complicated disciplinary coupling is usually included. Thus, to improve an overall performance of the satellite system, it needs to consider the relationship among the disciplines comprehensively.

The operation and the operating principle of the disclosure are described below according to an embodiment.

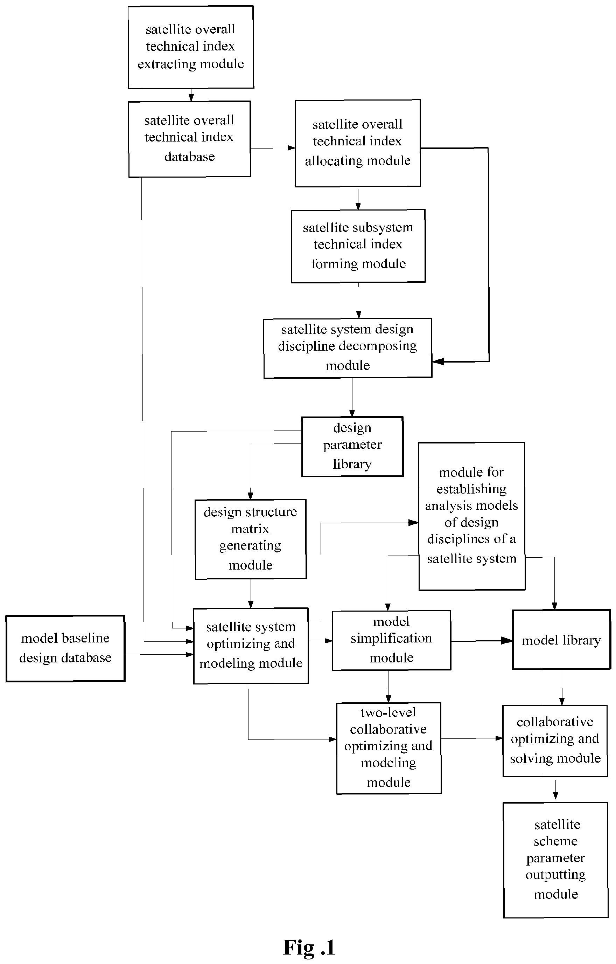

In this embodiment, the hardware environment for running the system for designing the overall scheme of the satellite uses a client/server (C/S) framework, which includes a client and a server, and a distributed collaborative environment for a satellite overall scheme is achieved through a local area network. As shown in Figure 1, the client runs a satellite system design discipline analysis and modeling module; the server runs a satellite design parameter input system, modules in a FPGA system except for the satellite system design discipline analysis and modeling module, a central database storage and management system, and a satellite scheme parameter outputting module. The hardware environment and operating environment of the client and server are configured as follows.

The server is a core of the satellite scheme design system, and is configured to manage database simulation tasks and schedule tasks. The server is configured with a memory with a capacity greater than 64G, a hard disk with a capacity greater than 50t, a CPU with a clock speed higher than 2.93Hz, and an operation system, which is win 7 or a higher version, having a function memory data protection.

The client is configured for analyzing and modeling disciplines in satellite system design. The client is required to be configured with a memory with a capacity greater than 8G, a hard disk with a capacity greater than It, a CPU with a clock speed higher than 2.93Hz, and an operating system which is win 7 or a higher version.

The client and the server communicate by IP accessing using a bandwidth more than 10M.

1. system index extracting module

The mobile communication satellite is mainly configured to provide continuous communication services for various small mobile user terminals, where a core task is to provide an equivalent isotropic radiated power (EIRP) and a gain to noise temperature ratio of a receiving system (G/T) sufficiently high for handheld terminals, and ensure uniform and seamless coverage of communication services in a service area. The mobile communication satellite system has a complicated structure, thus it is necessary to consider coupling among multiple disciplines, and overall optimization among various disciplines during the overall design, to determine optimal parameters of the overall scheme.

Functional indexes and non-functional indexes as required by the mobile communication satellite design tasks are extracted. The functional indexes are extracted based on the payload of the satellite satisfying the design tasks, and include coverage, direction and communication capacity, etc. The non-functional indexes are extracted mainly based on a satellite platform satisfying the satellite system overall design, and include weight, power, heat consumption, external envelop size, center of mass, basic structural frequency, lifetime, costs and reliability of the whole satellite.

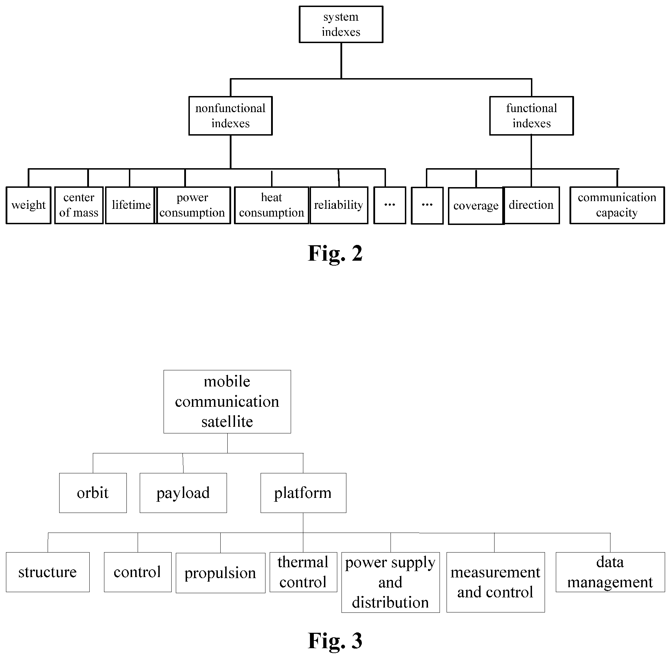

The satellite overall technical index extracting module extracts system indexes of the mobile communication satellite, forms an index set and stores the index set into a satellite overall technical index database. Figure 2 shows a configuration of system indexes of a mobile communication satellite system, where the system indexes include functional indexes and nonfunctional indexes; the functional indexes include coverage, direction and communication capacity, etc; and the non-functional indexes include weight, center of mass, lifetime, power consumption, heat consumption, and reliability, etc.

2. overall technical index allocating module and formation of technical requirements

According to the overall research scope and design tasks (including the orbit, the payload and the satellite platform, where the satellite platform includes subsystems such as structure, control, propulsion, thermal control, electrical power control and distribution, measurement and control, and data management) of the satellite system, the extracted system indexes are allocated to subsystems of the orbit, the payload and the satellite platform, to form technical requirement files for scheme designs of the subsystems.

3. decomposition and definition of satellite design disciplines

According to the technical requirements of the subsystems of the orbit, the payload and the satellite platform of the satellite, and the satellite system performance indexes, the subsystems are decomposed into multiple different independent design disciplines, to decompose the satellite overall design tasks into design disciplines (a complicated subsystem may be decomposed into multiple different design disciplines according to design subtasks of the subsystem).

Through decomposition of the satellite design disciplines according to the foregoing rule, the configuration of the design disciplines related to the overall design of the mobile communication satellite is achieved, as shown in Figure 3, including orbit, payload, control, propulsion, structure, thermal control, electrical power supply and distribution, measurement and control, data management, and performances (coverage, weight, center of mass, and lifetime, etc). In this embodiment, measurement and control, and data management has less correlation with optimization of the scheme design, and the design disciplines of measurement and control, and data management are not discussed here.

Based on the decomposition of the system design disciplines, design tasks and input parameters and output parameters of the design disciplines are determined, and the input and out parameters are stored into a design parameter library.

In an embodiment, the design tasks and the input parameters and output parameters of the design disciplines of the mobile communication satellite are defined as follows.

a. The orbit discipline is responsible for calculating an instantaneous position of the satellite. In an embodiment, an orbit position provides a base point for a boresight direction of a multi-beam antenna, the input parameters are six orbital elements $\Omega,i,a,e,\omega,F$, which are right ascension of ascending node, orbit inclination, eccentricity, argument of perigee, and eccentric anomaly, respectively; and the output parameters are orbit position $(x_i, y_i, z_i)$, right ascension and declination $(\alpha_i, \delta_i)$ of the satellite in an inertial system, and geographic longtitude and latitude $(\lambda_s, \delta_s)$ of the satellite in a geographic coordinate system.

b. The payload discipline is mainly responsible for design of an antenna and a configuration of a transponder. In an embodiment, for design of a central boresight direction of the multi-beam antenna and arrangement of an edge sub-beam, the input parameters are stationary position of the satellite, the arrangement and direction of the edge sub-beam, latitude of a nominal direction of the central boresight of the antenna, and latitude of a dynamic direction of the central boresight of the antenna; and the output parameters include direction of the antenna relative to a geocentric geographical system, direction of the antenna with respect to a satellite system, an installation position of the edge sub-beam, and weight and power of the subsystem of the payload.

c. The control discipline is mainly responsible for control of orbit and attitude of a satellite in flight. In an embodiment, attitude offset of the boresight direction of the antenna is mainly controlled, the input parameters include instantaneous orbit position, and the boresight direction of the antenna in a dynamic condition; and the output parameters include a control rule of offset of three-axis attitude for controlling a dynamic boresight direction of an antenna, an intersection point between a sub-beam and a service area, and weight and power of the control subsystem.

d. The propulsion discipline is mainly responsible for layout and parameter configuration for a thruster, and orbit transfer, orbital maintenance and attitude control or momentum wheel unloading speed increments, and budget of total propellant. In this embodiment, layout and installment of a 10N thruster are discussed. The input parameters include layout parameters of the thruster, orbit-transfer strategy, station-keeping strategy, and orbit inclination. The output parameters include control forces, control torques, disturbance torques, required speed increments, and consumptions of the propellant for the orbital maintenance and the attitude control, and weight and power of the propulsion subsystem.

e. The structure discipline is mainly responsible for designing configuration topology, geometry, and parameters of composite material for the satellite (including external parts thereof), and calculating fundamental frequencies of the whole satellite in an undeployed state and in a deployed state, and weight of the structure subsystem. According to the embodiment, design of structure parameters of the composite material, and structural design of a big external part of the satellite i.e., a deployed antenna mast, are mainly provided. For the design of structure parameters, the input parameters include primary bearing structure (bearing cylinder), geometry of the platform (north and south panels, north and south separators, bearing cylinder, west and east panels, a bracket, west and east separators, earth-facing panel, middle panel and panel facing away from the earth), ply thickness and thickness of honeycomb core for composite material of panels; and the output parameters includes the fundamental frequency of the whole satellite in the deployed state and weight of the structure subsystem. For the deployed antenna mast, the input parameters include geometrical structure of a big mast and a small mast, and mass information of each part; and the output parameters include center of mass of the satellite system and lateral eccentricity of center of mass of the satellite in the deployed sate.

f. The thermal control discipline is mainly responsible for designing a thermal control scheme of the whole satellite. In an, the input parameters include heat dissipation requirement of the whole satellite, installment positions of stand-alone devices, orbital altitude and heat loss of the devices; the output parameters include size of a dissipating board on the satellite, heat dissipation capability of the whole satellite, weight and power of the thermal control subsystem.

g. The electrical power discipline is mainly responsible for designing a scheme of a power system of the whole satellite. In an embodiment, the input parameters include power requirement of the whole satellite (power consumption for devices), geometrical parameters of a solar wing, conversion efficiency of solar battery array, type of an accumulator, time of earth shadow area; and the output parameters include output power of the whole satellite, capacity of the accumulator, size of the solar wing, and weight and power of the power supply and distribution subsystem.

h. The coverage discipline is mainly responsible for evaluating coverage characteristics of the antenna. In an embodiment, the input parameters include an intersection point between an edge sub-beam and a service area at any moment; and the output parameter include coverage determination index and coverage quality parameter.

i. The weight discipline is mainly responsible for estimating weight of the whole satellite. According to the embodiment, the input parameters include payload, control, propulsion, structure, thermal control, weight of the power supply and distribution subsystem, weight of the propellant, and weights for other parts, and the output parameter is weight of the whole satellite.

j. The center of mass discipline is mainly responsible for estimation of positions of the center of mass of the satellite system at different flighting moments. In an embodiment, the input parameters include a center of mass of a system with an undeployed antenna and a center of mass of a system with a deployed antenna. And the output paramters include the center of mass and lateral eccentricity of the satellite system with a deployed antenna.

k. The lifetime discipline is responsible for designing operating lifetime. In an embodiment, the input parameters include minimum requirement of operating lifetime, structural weight, propellant consumption and launch weight, and the output parameters include weight of propellant theoretically carried, propellant actually consumed, and residual propellant between propellant theoretically carried and propellant actually consumed, and actual operating lifetime.

4. satellite overall scheme design structure matrix

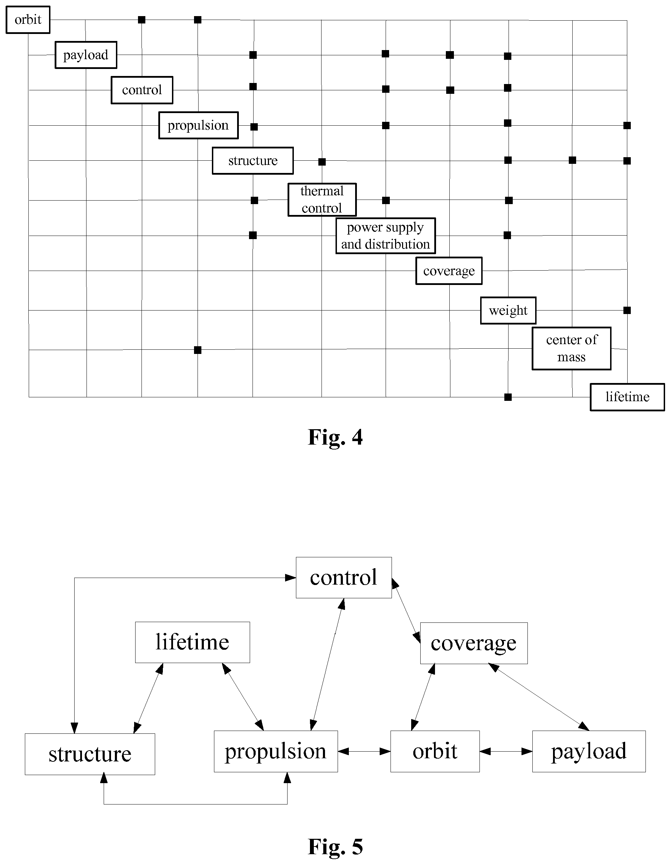

According to the design content and the input parameters and output parameters of the design disciplines defined above, design structure matrix representation of the satellite overall scheme is obtained by a design structure matrix generating module. Shared design variables for different design disciplines are obtained by performing intersection calculation on corresponding input parameters of the design disciplines of the mobile communication satellite; and coupled state variables for every two of the design disciplines are obtained by performing intersection calculation on input variables of a design discipline and output variables of another design discipline, and performing intersection calculation on output variables of a design discipline and input variables of an another design discipline, where an empty intersection is denoted as 0, indicating that the two disciplines are uncorrelated, and non-empty intersection is denoted as 1, indicating that the two disciplines are correlated or coupled. Figure 4 shows a overall design structure matrix of a mobile communication satellite, where coupling relations between 11 different design disciplines included in the overall scheme design of the mobile communication satellite are presented.

5. satellite system multidisciplinary optimization modeling

a. In an embodiment, a design scheme of an orbit with a small inclination is used for the mobile communication satellite, coverage of the multi-beam antenna, which is the functional index, is contradictory to the operating lifetime of the satellite, which is the nonfunctional index, and the design of an orbit with a small inclination is closely correlated to disciplines of orbit, control, weight, center of mass, structure, and propulsion, thus it is necessary to combine the multiple disciplines to perform optimization design to form an overall design scheme, where the coverage requirement is met and the operating lifetime of the satellite is prolonged.

In an embodiment, the coverage and lifetime in the system index set are used as a system optimization object, and the output parameters such as weight, center of mass, lifetime and coverage are used as constraint variables.

The disciplines related to the optimization object, design constraint and design variables are determined as design disciplines involved in the optimization design. Figure 5 shows design disciplines correlated to an overall optimization design object of a mobile communication satellite, including coverage, lifetime, structure, control, propulsion, orbit and payload, where the design disciplines are coupled with each other. The characteristics of weight and center of mass of the whole satellite are directly output by the structure discipline and are not considered as independent design disciplines.

By additionally considering baseline type information in the database, the input parameters and output parameters corresponding to the design disciplines involved in the optimization are determined as an optimization design variable set.

b. According to the three optimization elements defined above, an optimization issue for multidisciplinary overall scheme of the mobile communication satellite is acquired, and may be mathematically described as:

$$\text{D.V.} \quad \boldsymbol{X} = \left\{ \begin{matrix} i, \lambda_{a0}, \delta_{a0}, \lambda_a, \delta_a, \boldsymbol{X}_{struc}, \boldsymbol{S} \\ l_1, \alpha_1, \beta_1, l_2, \alpha_2, \beta_2 \end{matrix} \right\}$$

$$\min \quad E(\boldsymbol{X},\boldsymbol{Y}), \sigma(\boldsymbol{X},\boldsymbol{Y}); \quad \max \quad L(\boldsymbol{X},\boldsymbol{Y})$$

$$\text{s.t.} \quad \boldsymbol{g}_{cover}(\boldsymbol{X},\boldsymbol{Y}): \forall \Delta \gamma_j \le \theta_b$$

$$\boldsymbol{g}_{struc}(\boldsymbol{X},\boldsymbol{Y}): f_x, f_y \ge f_{h0}; f_z \ge f_{v0}$$

$$\boldsymbol{g}_{gx}(\boldsymbol{X},\boldsymbol{Y}): \Delta x_m, \Delta y_m \le l_2; \Delta z_m \le l_3, \Delta r \le d_0$$

$$\boldsymbol{g}_{con}(\boldsymbol{X},\boldsymbol{Y}): M_d \le M_0$$

$$\boldsymbol{g}_{sys}(\boldsymbol{X},\boldsymbol{Y}): m \le m_{max}, L \ge L_0$$

$$\boldsymbol{X}_{struc}^L \le \boldsymbol{X}_{stuc} \le \boldsymbol{X}_{struc}^U, \boldsymbol{S}^L \le \boldsymbol{S} \le \boldsymbol{S}^U$$

$$\tag{1}$$

In the formula, $E$ and $\sigma$ are redundancy and uniformity of coverage quality parameters respectively, $L$ is actual operating lifetime of the satellite; and $\boldsymbol{X}$ is a design vector, where orbit inclination $i$ is a design variable of the orbit discipline, the nominal direction $\lambda_{a0}, \delta_{a0}$ of the antenna boresight is a design vector of the payload discipline, dynamic direction $\lambda_a, \delta_a$ of the antenna boresight is a design vector of the control discipline, composite material parameters $\boldsymbol{X}_{struc}$ and $l_1, \alpha_1, \beta_1, l_2, \alpha_2, \beta_2$ are design vectors of the structure discipline, and $\boldsymbol{S}$ is a design vector of the propulsion discipline; $\boldsymbol{Y}$ is a state vector; $\boldsymbol{g}_{cover}$, $\boldsymbol{g}_{struct}$, $\boldsymbol{g}_{gx}$, $\boldsymbol{g}_{con}$, and $\boldsymbol{g}_{sys}$ are respective related constraint vectors for the coverage discipline, the structure discipline, the control discipline and performance discipline, and $\boldsymbol{X}_{struc}^L$ and

$X_{stuc}^{U}$, $S^L$ and $S^U$, are upper and lower limits of the design vectors $X_{stuc}$ and $S$, respectively.

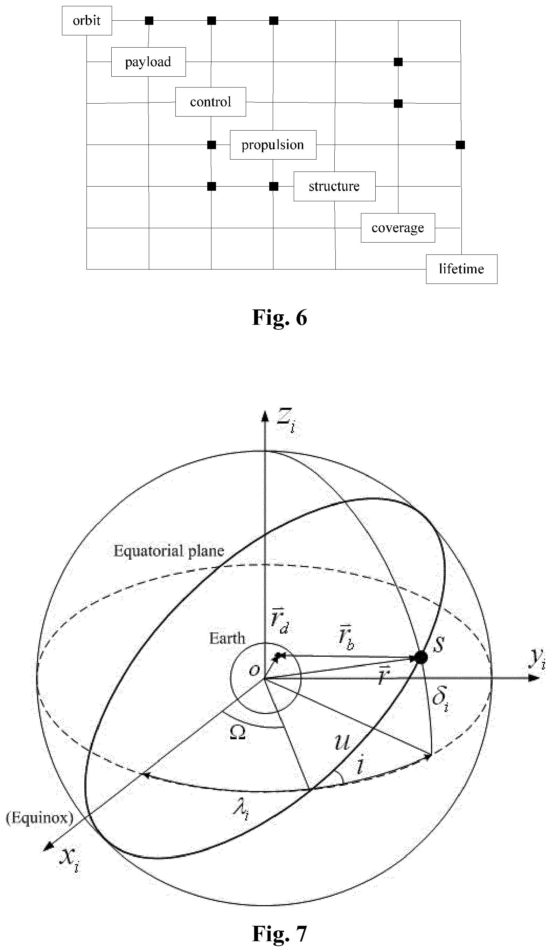

c. A structure matrix of the optimization design is obtained by performing intersection calculation on the design disciplines involved in the optimization and the structure matrix of the overall design, as shown in Figure 6. The optimization design structure matrix includes seven design disciplines, which are orbit, payload, control, propulsion, structure, coverage and lifetime, where a black square between two design disciplines indicates there is coupling between the two disciplines.

6. establishment of analysis models of the design disciplines involved in the optimization

The analysis models of the design disciplines involved in the optimization are established respectively, according to the tasks and the input parameters and output parameters of the design disciplines which are defined by the design discipline decomposing module of the mobile communication satellite system, where the design disciplines include an orbit discipline, a payload discipline, a structure discipline, a control discipline, a propulsion discipline, a coverage discipline and a lifetime discipline. The analysis models are described in detail as follows.

6.1 orbit discipline

An orbit position $(x_i, y_i, z_i)$ of the satellite in an inertial system is calculated based on orbit elements $(a, e, \Omega, i, \omega)$, and is expressed as :

$$\begin{bmatrix} x_i \\ y_i \\ z_i \end{bmatrix} = r_i \begin{bmatrix} \cos\Omega\cos u - \sin\Omega\sin u \cos i \\ \sin\Omega\cos u + \cos\Omega\sin u \cos i \\ \sin u \sin i \end{bmatrix} \tag{2},$$

where $r_i = a(1-e^2)/(1+e\cos f(t))$, $u = \omega + f(t)$, true anomaly $f(t)$ is acquired through solving Kepler equation, and accordingly,

$f(t) = \tan(f/2) = \sqrt{(1+e)/(1-e)}\tan(E/2)$, $a$ represents a semi-major axis of the orbit, $e$ represents eccentricity, $\Omega$ represents right ascension of ascending node, $i$ represents orbit inclination, and $\omega$ represents argument of perigee.

Right ascension and declination $(\alpha_i, \delta_i)$ of the satellite in the inertial system may be acquired by using formula (2) and a spherical triangle or rectangular coordinates relationship shown in Figure 7, which is

$$\alpha_i = \arctan(y_i/x_i); \quad \delta_i = \arcsin(z_i/r_i) \tag{3}.$$

$(\alpha_i, \delta_i)$ is converted into longitude and latitude $(\lambda_s, \delta_s)$ in a geocentric geographic system, where

$$\lambda_s = \alpha_i - \alpha_G; \quad \delta_s = \delta_i \tag{4}$$

In formula (4), $\alpha_G$ is Greenwich ascension and is equal to $\alpha_{G0} + \omega_e t$, $\alpha_{G_0}$ is a Greenwich angle at initial time, and $\omega_e$ is the rotational angular velocity of the earth.

6.2 payload discipline

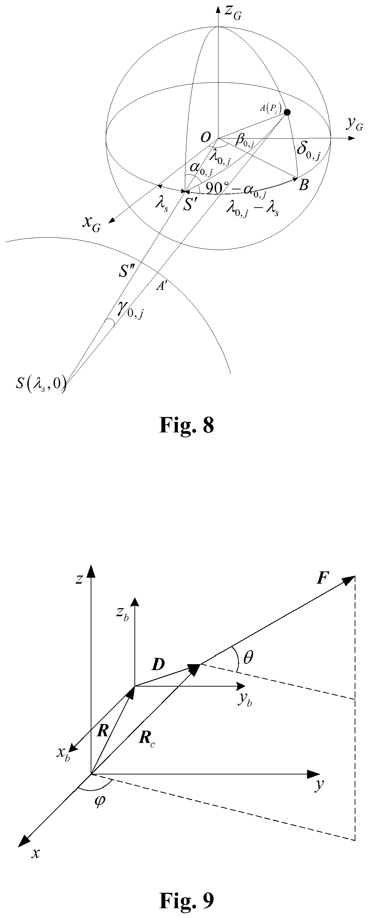

As shown in Figure 8, $S_0(\lambda_{s0}, 0)$ is the stationary position of the mobile communication satellite, A or $S'$ is a position of a subastral point, $P_j(\lambda_{0j}, \delta_{0j})$ and $(\lambda_{sb0j}, \delta_{sb0j})$ are a position of an intersection between the central boresight of the antenna and the ground, and a position of an intersection between a boresight of a sub-beam $j$ and the ground, a geocentric angle $\beta_{0j}$ of the sub-beam $j$ relative to the subastral point and an azimuth angle $\alpha_{0j}$, and an angle between beam boresight and the satellite $\bar{z}_b$ may be calculated by using a spherical triangle $ABS'$ and a triangle $ASO$, and have respective expressions as

$$\beta_{0,j} = \arccos\left[\cos\delta_{0,j}\cos\left(\lambda_{0,j} - \lambda_{s0}\right)\right] \tag{5},$$

$$\alpha_{0,j} = \arccos\left[\sin\delta_{0,j}\big/\sin\beta_{0,j}\right] \tag{6},$$

and

$$\gamma_{0,j} = \arctan\left[R\sin\beta_{0,j}\big/\left(H - R_e\left(1 - \cos\beta_{0,j}\right)\right)\right] \tag{7},$$

where $R_e$ is the earth radius, $H$ is a distance between the satellite and the subastral point, and the $(\gamma_{0,j}, \alpha_{0,j})$ determines an installation position of the sub-beam $j$ in the satellite system, and configuration of beams relative to the central boresight.

Similarly, right ascension and declination of the radius vector $\vec{r}_{sb0,j}$ of the boresight of the sub-beam relative to the satellite system may be represented, by using $(\gamma_{0,j}, \alpha_{0,j})$, as:

$$\beta_{0,j} = \arccos\left(\sqrt{1 - \cos^2\alpha_{0,j}\sin^2\gamma_{0,j}}\right)$$
$$\alpha_{0,j} = \arccos\left(\cos\gamma_{0,j}\big/\cos\beta_{0,j}\right) \tag{8}.$$

Rectangular coordinate components and in the satellite system $ox_by_bz_b$, i.e., $(x_{a0}, y_{a0}, z_{a0})$ corresponding to the pointing direction $\vec{r}_{a0}$ of the central boresight of the antenna, and $(\hat{x}_{bsb0,j}, \hat{y}_{bsb0,j}, \hat{z}_{bsb0,j})$ corresponding to a central pointing direction $\vec{r}_{sb0,j}$ of any sub-beam, may be further acquired through formulas in spherical coordinates according to equations (5) to (8).

The installation position of central pointing direction of the sub-beam in the geocentric geographic system may be acquired based on a conversion matrix from the satellite system to the geocentric geographic system.

6.3 structure discipline

(1) finite element analysis model for fundamental frequency and quality characteristic of the whole satellite

A Patran pretreatment tool of MSC Corporation is used to divide the whole satellite structure into grid cells, establish a high-precision finite element analysis model as an analysis model of the structure discipline, and perform a modal analysis based on a Nastran solver. Establishing an approximation model is necessary due to a complicated structure of the whole satellite, and long calculation time of the modal analysis.

(2) configuration analysis model for deployable masts of an antenna

A large deployable antenna includes a big mast, a small mast and a reflector. Design parameters of configuration of the big and small masts include a connection position $A(x_A, y_A, z_A)$ between the big mast and the satellite body, azimuth angle $\alpha_1$ and elevation angle $\beta_1$ of the big mast relative to the east panel of the satellite platform, and length of the big mast $l_1$; and angle $\alpha_2$ and elevation angle $\beta_2$ of the small mast relative to the east panel of the satellite platform, and length of the small mast $l_2$. To ensure structural stiffness of the small mast, section diameters of the big and small masts are not changed, i.e., density per unit length is constant.

For convenience in calculating the center of mass of the satellite system, a mechanical coordinate system $O\text{-}XYZ$ is defined as follows. The origin is located on a mechanical separation surface between the satellite and a launcher, and is located at a center of a theoretical circle of a docking frame, the positive direction of $x$ axis points from the origin to the east panel of the satellite, the positive direction of $y$ axis points from the origin to the south panel, and the positive direction of $z$ axis points from the origin to an earth-facing panel. Centers of mass for parts of the satellite system and the center of mass of the system with a deployed antenna are calculated below by reference to the mechanical coordinate system $O\text{-}XYZ$

Mass $m_{sat}$ and center of mass $(x_b, y_b, z_b)$ of the satellite body and masses $m_s$ and centers of mass $(x_s, \pm y_s, z_s)$ of the south and north solar wings are known, then mass $m_{all}$ and center of mass $(x_{bs}, y_{bs}, z_{bs})$ of an assembly of the satellite body and the south and north solar wings are

$$m_{all^-} = m_{sat} + 2m_s$$
$$x_{bs} = \left(m_{sat}x_b + 2m_s x_s\right) / m_{all^-}$$
$$y_{bs} = m_{sat}y_b / m_{all^-}$$
$$z_{bs} = \left(m_{sat}z_b + 2m_s z_s\right) / m_{all^-} \tag{9}.$$

The length $l_2$ of the small mast can be calculated from the length of the big mast and the position of the reflector. It is assumed that the density of the big mast is $\rho_1$ (kg/m), the density of the small mast is $\rho_2$(kg/m), then respective masses of the big and small masts are $l_1\rho_1$ and $l_2\rho_2$. If mass $m_r$ and center of mass $(x_r, y_r, z_r)$ of the reflector are known, then total mass $m_{all}$ of the satellite system after orbit transfer is

$$x_1 = x_A + l_1 \sin\alpha_1 / 2$$
$$y_1 = y_A + l_1 \cos\alpha_1 \cos\beta_1 / 2$$
$$z_1 = z_A + l_1 \cos\alpha_1 \sin\beta_1 / 2 \tag{11}$$

Similarly, a position $(x_B, Y_B, Z_B)$ of a jointing point B between the small mast and the big mast in the mechanical coordinate system may be calculated.

Similarly, a local reference coordinate system $ox_B y_B z_B$, coordinate axises of which are parallel with the three axes of the mechanical coordinate system respectively, is established at the jointing point B between the small mast and the big mast, the coordinates of the center of mass of the small mast may be calculated, and calculation formulas thereof are as follows:

$$x_2 = x_B + l_2 \sin\alpha_2 / 2$$
$$y_2 = y_B + l_2 \cos\alpha_2 \cos\beta_2 / 2$$
$$z_2 = z_B + l_2 \cos\alpha_2 \sin\beta_2 / 2 \tag{12}.$$

The center of mass $(x_{m'}, y_{m'}, z_{m'})$ of the satellite system with a deployed antenna may be acquired by the calculation formulas of the center of mass of the assembly, which is :

$$\begin{cases} x_{m'} = \left(m_{all^-} x_{bs} + l_1\rho_1 x_1 + l_2\rho_2 x_2 + m_r x_r\right) / m_{all} \\ y_{m'} = \left(m_{all^-} y_{bs} + l_1\rho_1 y_1 + l_2\rho_2 y_2 + m_r y_r\right) / m_{all} \\ z_{m'} = \left(m_{all^-} z_{bs} + l_1\rho_1 z_1 + l_2\rho_2 z_2 + m_r z_r\right) / m_{all} \end{cases} \tag{13}.$$

A lateral eccentricity of the center of mass of the satellite system is a shift of the center of mass of the satellite system with a deployed antenna relative to the center of mass of the satellite system with an undeployed antenna, and may be acquired by subtracting the center of mass of the satellite system with a deployed antenna by the center of mass of the satellite system with an undeployed antenna,

To ensure that the position of the reflector relative to a feed is fixed, and the small mast can be connected to the reflector, a component dis_ac of a distance of a line segment between an installation root of the big mast and an end C of the small mast along X axis in the satellite system is required to be smaller than a minimal distance.

6.4 control discipline

In the inertial system, it is defined that $\vec{r}$ is the radius vector of the mobile communication satellite $\vec{r}$ $\left(\lambda_s, \delta_s\right)$, $\vec{r}_b$ is a radius vector from the mobile communication satellite to a point $(\lambda_a, \delta_a)$ to which the central boresight of the antenna in the dynamic operation condition is directed, and $\vec{r}_d$ is a radius vector from the center of the earth to the point to which the central boresight of the antenna in the dynamic operation condition is directed, then $\vec{r}_b = \vec{r}_d - \vec{r}$, where $\vec{r}$ and $\vec{r}_d$ are

$$\vec{r} = r \begin{bmatrix} \cos\delta_s \cos(\lambda_s + \alpha_G) \\ \cos\delta_s \sin(\lambda_s + \alpha_G) \\ \sin\delta_s \end{bmatrix}; \quad \vec{r}_d = R_E \begin{bmatrix} \cos\delta_a \cos(\lambda_a + \alpha_G) \\ \cos\delta_a \sin(\lambda_a + \alpha_G) \\ \sin\delta_a \end{bmatrix} \quad (14),$$

respectively,

where, $\alpha_G$ is Greenwich ascension and is equal to $\alpha_{G0} + \omega_e t$, $\alpha G_0$ is a Greenwich angle at initial time, and $\omega_e$ is the rotational angular velocity of the earth.

For a mobile communication satellite with small inclination (0-6.5degree), a trajectory of an orbit in the geographic coordinate system is 8-shaped and is symmetric about an ascending node ($\lambda_{s0}$,0), along the south-north direction, and an asymmetric 8-shaped trajectory, relative to the point of the earth to which the antenna is directed, is caused. From the time that the satellite is located at the ascending node, at time t, the position of the satellite is ($\lambda_{s0} + \Delta\lambda_s, \Delta\delta_s$), the position of the point of the earth to which the antenna is directed is ($\lambda a_0 + \Delta\lambda_a$, $\delta_{a0} + \Delta\delta_a$), and through attitude offset, dynamic directions $\vec{r}_a$ and $\vec{r}_b$ of the antenna boresight are same ( $\vec{r}_{a0} // \vec{r}_{b0}$ in the standard condition), to ensure continuous coverage of the antenna on a service area.

A rule for controlling three-axis attitude offset of the satellite is:

$$\begin{bmatrix} \varphi_1 \\ \theta_1 \\ \psi_1 \end{bmatrix} = \begin{bmatrix} arc\sin\left(y_{a0}/\sqrt{y_b^2 + z_b^2}\right) - arc\tan\left(y_b/z_b\right) \\ arc\sin\left(x_b/\sqrt{x_{a0}^2 + z_{a0}^2}\right) - arc\tan\left(x_{a0}/z_{a0}\right) \\ \arctan(\tan i \cos u) = \arctan[i\cos(\omega + f)] \end{bmatrix} \quad (15),$$

where $f$ represents true anomaly, $u$ represents argument of latitude, ($x_{a0}, y_{a0}, z_{a0}$) represents rectangle coordinate components of direction $\vec{r}_{a0}$ of the central boresight of the antenna and a central direction $\vec{r}_{sb0,j}$ of a sub-beam in the satellite system $ox_b y_b z_b$, $\varphi_1$ is a roll angle, $\theta_1$ is a pitch angle, and $\psi_1$ is a yaw angle.

By performing control according to the acquired rule for controlling three-axis attitude offset of the satellite, the central boresight of the antenna points to the target point. A vector equation is formed by using the positions of the satellite, the center of the earth and the sub-satellite point, and combined with the installation position of the sub-beam of the antenna relative to the satellite system, after control of the attitude offset of the satellite geographic latitude and geographic longitude ($\delta_{sb,j}, \lambda_{sb,j}$) of an intersection between the sub-beam and the earth at a dynamic orbital position may be acquired, and may be expressed as

$$\begin{cases} \lambda_{sb,j} = arc\tan\left[\left(y_i + r_{sbb}\hat{y}_{isb,j}\right)/\left(x_i + r_{sbb}\hat{x}_{isb,j}\right)\right] - \alpha_G \\ \delta_{sb,j} = arc\sin\left[\left(z_i + r_{sbb}\hat{z}_{isb,j}\right)/R_E\right] \end{cases}$$

where $r_{sbb}$ is a distance between the position of the satellite and the intersection between the sub-beam and the earth,

$R_E$ is the radius of the earth, ($\hat{x}_{isb,j}$ $\hat{y}_{isb,j}$ $\hat{z}_{isb,j}$) are components of the unit pointing vector $\vec{r}_{sb,j}$ of the sub-beam in the inertial system, $\alpha_G$ is Greenwich right ascension, and ($x_i$, $y_i$, $z_i$) is position information of the intersection between the center of sub-beam and the earth in the geographic system.

6.5 propulsion discipline

(1) thruster layout model

To describe installation information for a 10N thruster, two reference systems, a mechanical coordinate system and a satellite body coordinate system, are established, where the mechanical coordinate system is defined as the foregoing mechanical coordinate system. The satellite body coordinate system is defined as follows. The origin is the center of mass of the satellite system, and $x_b, y_b, z_b$ are parallel with three axes of the mechanical coordinates system respectively. For a single thruster, a thrust direction is determined by an azimuth angle $\varphi$ an elevation angle $\theta$ of the thruster relative to the satellite body system, and an installation position is determined by a position vector $\boldsymbol{R}$=[x,y,z] of the thruster in the mechanical coordinate system.

Figure 9 shows a thrust relationship in a vector space, $\varphi \in$[0,360°] is an angle between a projection of a trust vector $\boldsymbol{F}$ on a *oxy* plane of a mechanical system and x axis in the *oxy* plane of the mechanical system, $\theta \in$[-90°,90°] is an angle between the propulsion vector $\boldsymbol{F}$ and a $ox_b y_b$ plane of the satellite body system, $\boldsymbol{R}_c[x_c, y_c, z_c]$ is a position vector of the center of mass of the whole system in the mechanical coordinate system, then $\boldsymbol{D}=\boldsymbol{R}-\boldsymbol{R}_c$ =[x-$x_c$,y-$y_c$,z-$z_c$] is a position vector of the thruster in the coordinate system of the satellite body, and is also denoted as ($x_D, y_D, z_D$).

It is assumed that angles between the trust vector $\boldsymbol{F}$ and the three axes $x_b, Y_b, Z_b$ of the satellite body are $\alpha, \beta, \gamma$ respectively, it is may be acquired through a geometrical relationship that

$$\alpha = \arccos\left(\cos\theta\cos\varphi\right)$$
$$\beta = \arccos\left(\cos\theta\sin\varphi\right)$$
$$\gamma = \arccos\left(\sin\theta\right) \qquad (16),$$

Components of the propulsion vector $\boldsymbol{F}$ on the three axes are

$$\boldsymbol{F} = \begin{bmatrix} F\cos\alpha & F\cos\beta & F\cos\gamma \end{bmatrix} \qquad (17),$$

where, $\boldsymbol{F}$ is a propulsion vector for a single thruster, the three components correspond to thrust components along the axes respectively. Respective control moments $M_x, M_y, M_z$ about the three axes generated by the single thruster are

$$M_x = |\boldsymbol{F}|\left(z_D\cos\beta - y_D\cos\gamma\right)$$
$$M_y = |\boldsymbol{F}|\left(x_D\cos\gamma - z_D\cos\alpha\right)$$
$$M_z = |\boldsymbol{F}|\left(y_D\cos\alpha - x_D\cos\beta\right) \qquad (18)$$

Operation modes of thrusters for east-west and south-north station-keepings of the mobile communication satellite are known, four 10N thrusters with 2A to 5A currents respectively are mainly designed, installation angles ($x_{iA}, y_{iA}, z_{iA}$) and installation positions ($\alpha_{iA}, \beta_{iA}$) for the thrusters are selected respectively as a design vector $\boldsymbol{S}$ ($i$ = 2,···,5), then control forces and control moments for operation modes of combination of the thrusters for the east-west and south-north station-keepings may be acquired.

(2) calculation of speed increment

It is known that an inclination angle that the satellite enters into the orbit is $i_T$, and an target inclination angle of an orbit is $i$, apogee is selected for ignition and orbit transfer, the speed increment, a speed vector before the orbit transfer and a speed vector after the orbit transfer form a vector triangle. Semi-major axis of the orbit is $a_1$, and a distance

between the satellite and the center of the earth is $r_a$, and through the vis viva equation, speed $V_1$ of the satellite at the apogee before the ignition and orbit transfer, and speed $V_2$ of the satellite at the apogee after the ignition and orbit transfer may be acquired, and respectively are

$$V_1 = \sqrt{\frac{2\mu}{r_a} - \frac{\mu}{a_1}}$$

$$V_2 = \sqrt{\frac{\mu}{r_a}} \tag{19},$$

where $\mu$ is the gravitational constant of the earth, which is $3.98605 \times 10^{14}$ m$^3$/s$^2$.

Speed increment $\Delta V_T$ required by the orbit transfer may be acquired through a vector triangle of the speed according to the cosine law, and a calculation formula thereof is

$$\Delta V_T = \sqrt{V_1^2 + V_2^2 - 2V_1 V_2 \cos \Delta i} \tag{20},$$

where $V_1$ represents the speed of the satellite at the apogee before the ignition, $V_2$ represents the speed of the satellite at the apogee after the ignition, and $\Delta i = i$ represents inclination increment.

A speed increment required for station keeping of a north-south orbit is

$$\Delta v_{pns} = 2v_0 \sin\left(\Delta i / 2\right) \tag{21}$$

where $V_0$ represents the speed of the satellite in a stationary orbit; and
a speed increment required for station keeping of a west-east orbit is

$$\Delta v_{pwe1} = 1039.83 \left| \ddot{\lambda} \right| \tag{22}$$

where $\ddot{\lambda}$ represents an angular speed of longitude drift, which is determined by the longitude $\lambda_{s0}$ of the stationary position of the satellite.

Speed increments required by the attitude control and the momentum wheel unloading are calculated according to disturbance moment for the combination of the thrusters in the operating mode.

A thrust, a specific impulse, efficiency and a speed increment of an engine are known, consumed propellant may be calculated by formula (23):

$$\Delta m = m_0 \left( 1 - e^{-\Delta V / \left( I_{sp} \eta g \right)} \right) \tag{23},$$

where $\Delta V$ is the speed increment (m/s), including a speed increment of orbit transfer, a speed increment of position-keeping and a speed increment of attitude control; $\Delta m$ is consumption (kg) of the propellant; $I_{sp}$ is the specific impulse of the engine; $m_0$ is initial mass (kg) of the satellite; $\eta$ is an efficiency factor; and $g$ is the gravitational acceleration (m.s$^{-2}$).

Consumption $m_{fuel}$ of the propellant required for operation in the whole life cycle of the satellite is

$$m_{fuel} = m_{p,trans} + m_{p,orbit} + m_{p,attitude} + m_{f\_other} ,$$

where $m_{p,trans}$ is propellant required for orbit transfer, $m_{p,orbit}$ is propellant required for orbit keeping, $m_{p,attitude}$ is propellant required for the attitude control or momentum wheel unloading, and $m_{f\_other}$ is propellant required for other propulsion events.

## 6.6 coverage discipline

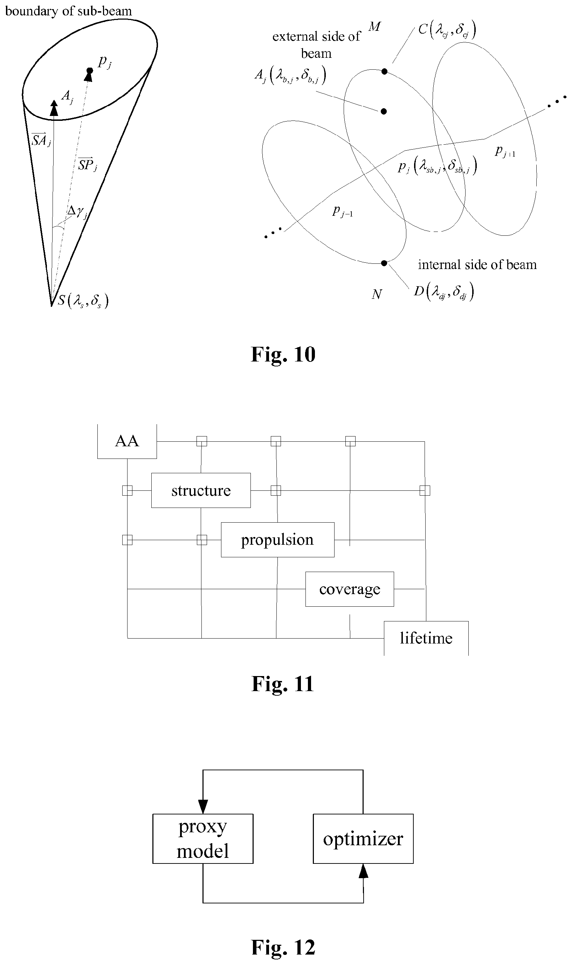

As shown in Figure 10, typical nominal points $A_j(\lambda_{b,j},\delta_{b,j})$ of boundary of territory are selected, where $j=1,2\cdots,I$, three adjacent sub-beams $p_{j-1},p_j,p_{j+1}$ for each nominal point $A_j$ are determined according to coverage in a nominal operation condition, angles $\gamma_{p-1},\gamma_p,\gamma_{p+1}$ of a vector $SA_j$ formed by jointing $A_j$ and the position of the satellite $S(\lambda_s,\delta_s)$ relative to central pointing vectors $\overline{SP}_{j-1}, \overline{SP}_j, \overline{SP}_{j+1}$ of the sub-beams $p_{j-1},p_j,pj_{+1}$ respectively are calculated. Taking the sub-beam $p_j(\lambda_{sb,j},\delta_{sb,j})$ as an example,

$$\overline{SA}_j = R_E \begin{bmatrix} \cos\varphi_{b,j}\cos\lambda_{b,j} \\ \cos\varphi_{b,j}\sin\lambda_{b,j} \\ \sin\varphi_{b,j} \end{bmatrix} - r \begin{bmatrix} \cos\delta_s\cos\lambda_s \\ \cos\delta_s\sin\lambda_s \\ \sin\delta_s \end{bmatrix}$$

$$\overline{SP}_j = R_E \begin{bmatrix} \cos\delta_{sb,j}\cos\lambda_{sb,j} \\ \cos\delta_{sb,j}\sin\lambda_{sb,j} \\ \sin\varphi_{sb,j} \end{bmatrix} - r \begin{bmatrix} \cos\delta_s\cos\lambda_s \\ \cos\delta_s\sin\lambda_s \\ \sin\delta_s \end{bmatrix} \qquad (24),$$

then the angle $\Delta\gamma_j$ between $\overline{SA}_j$ and $\overline{SP}_j$ is

$$\Delta\gamma_j = \arccos\left[\overline{SA}_j \cdot \overline{SP}_j \Big/ \left(\left\|\overline{SA}_j\right\| \cdot \left\|\overline{SP}_j\right\|\right)\right] \qquad (25).$$

Apparently, if at least one of $\Delta\gamma_{j-1},\Delta\gamma_j,\Delta\gamma_{j+1}$ is smaller than or equal to $\theta_b$ (half width of the sub-beam angle), the nominal point $A_j$ is inside the sub-beams, which indicates a full coverage state; otherwise, it is indicated that $A_j$ is located at an external side (*CM*) or an internal side (*DN*) of the sub-beam. Whether $A_j$ is located at the external side of the sub-beams or the internal side of the sub-beams may be directly determined through longitudes and latitudes of $A_j$ and $P_j$. The case that $A_j$ is located at the external side of the sub-beams indicates a under-coverage state; and the case that $A_j$ is located at the internal side of the sub-beams indicates a coverage state.

Furthermore, performance index of redundancy $E$ and uniformity $\sigma$ for coverage of the service area may be calculated from $\Delta\gamma_j$, and respectively are

$$E = \left(\Delta\gamma_1 + \cdots + \Delta\gamma_j \cdots + \Delta\gamma_n\right)\Big/n, \quad \sigma = \sqrt{\sum_{j=1}^{n}\left(\Delta\gamma_j - E\right)^2 \Big/ n} \qquad (26),$$

where $n$ is number of edge sub-beams, where $j = 1,2,\cdots,n$. The smaller $E$ is, the greater average coverage redundancy $\theta_b$-$E$ is, and the smaller $\sigma$ is, the more uniform coverages at different boundary regions are.

In practice, since coverage calculation and coverage determination includes all edge sub-beams and the boundary of the entire service area, it may result in an optimization problem with intensive calculation and too strong constraint, which is difficult to be solved. A model for evaluating coverage determination and coverage quality may be established by selecting a plurality of typical sub-beams and boundary nominal points corresponding thereto, to replace a practical complicated coverage calculation.

The selection includes: in a variable area of the directional point $(\lambda_a,\delta_a)$ of the central boresight of the antenna in the dynamic operation condition, using a uniform experimental design method to perform numerical experimentation of coverage simulation, and selecting, through statistics analysis, nominal points of the boundary of the territory which are most likely to be missed, and sub-beams corresponding thereto as typical representatives for evaluation of the coverage calculation.

6.7 lifetime discipline

Under a premise that a takeoff weight of the satellite is determined, the operating lifetime of the satellite depends on remaining mount of the propellant after the orbit transfer. The weight of the satellite includes dry weight and weight of the propellant, in this embodiment, the weight $m_{struc}$ of the structure subsystem and weight $m_{fuel}$ of consumption of the propellant are variable, and weight for subsystems of payload, power supply and distribution, measurement and control, digital management, control, propulsion and thermal control, weight of final assembly bracket, weight of special parts, margin and bob-weight, etc are not optimized, and are used as a constant, denoted as $m_{other}$, for calculation. The whole weight $m$ may be represented as

$$m = m_{struc} + m_{fuel} + m_{other} \qquad (27),$$

where $m_{struc}$ is acquired according to the analysis model of the structure discipline, and $m_{fuel}$ is acquired according to the analysis model of the propulsion discipline. According to the definition of the foregoing models, in a case that the takeoff weight of the whole satellite is determined, theoretically carried propellant is only relevant to the weight of the structure subsystem, that is, the saved weight of the optimized structure may increase the amount of propellant carried.

For better differentiation, the propellant theoretically carried is denoted as $m_{fuel0}$, the propellant actually carried is denoted as $m_{fuel}$, budget of the propellant is performed according to the propulsion discipline, design of upper limit of the operating lifetime of the satellite is determined by $m_{fuel0}$, where $m_{fuel0}$ is required to be greater than $m_{fuel}$.

It is assumed that other aspects, such as reliability, of the life requirement can all be satisfied, the actual operating lifetime $L$ (required to be greater than a theoretical design operating lifetime $L_0$) may be estimated, according to total remaining propellant after orbit transfer, in combination with actually consumed propellant in the total life cycle.

7. model simplification

a. simplification of the optimization design structure matrix

Serial design disciplines in the design structure matrix of the optimization issue of the satellite system are combined, to acquire a simplified design structure matrix for the optimization issue, as shown in Figure 11. After the simplification, the structure matrix of the overall optimization of the satellite totally includes five disciplines, i.e., AA, propulsion, structure, lifetime and coverage, where the AA discipline includes three design disciplines of orbit, payload and control.

b. simplification of design discipline analysis models

For analysis models of the design disciplines such as orbit, payload and control, calculation is relatively small, thus approximation models are required to be established; and for the structure discipline, finite element calculation is highly nonlinear and has huge calculation, thus an approximation model is required to be established.

An approximation model of quadratic response surface is used to establish the approximation model of the structure discipline. In the following, the approximation model is used to perform iterative solution for optimization. Figure 12 illustrates a principle for optimization and soling by using an approximation model. In the optimization process, an optimizer may directly invoke the approximation model of the structure discipline.

8. two-level collaborative optimization modeling

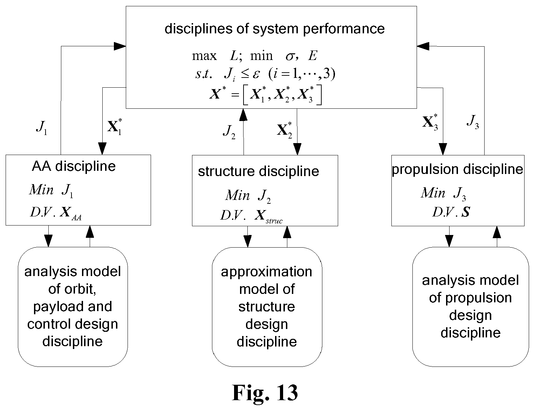

Design disciplines in weakest coupling with other design disciplines are selected as parent disciplines of calculation framework of the collaborative optimization. In this embodiment, coverage and lifetime are selected as parent disciplines. And AA, structure and propulsion are used as child disciplines. Figure 13 shows a calculation framework based on a two-level collaborative optimization method. The multidisciplinary collaborative optimization model of overall parameters of the mobile communication satellite includes an optimization model of parent disciplines and an optimization model of child disciplines, which are as follows.

8.1 optimization model of parent disciplines

$$\min \quad E,\sigma; \ \max \quad L$$
$$\text{s.t.} \quad J_1, J_2, J_3 \le \varepsilon$$
$$\text{find} \quad \boldsymbol{X}^* = \left[ \boldsymbol{X}_1^*, \boldsymbol{X}_2^*, \boldsymbol{X}_3^* \right] \qquad (23)$$

In formula (23), $E$, $\sigma$ are indexes for evaluating coverage, $L$ is operating lifetime of the satellite, $J_1$, $J_2$, $J_3$ are consistency constraints for parent disciplines, and $X_1^*, X_2^*, X_3^*$ are object design schemes which are passed, by the parent disciplines, to the three child disciplines of AA, structure and propulsion respectively.

8.2 optimization model of child disciplines

In order to decouple disciplines, input parameters for child design disciplines in the collaborative optimization include local design variables, shared design variables and coupled state variables. Compared with the input parameters defined in the original design disciplines, the coupled state variable is added in; and the output parameters include the output parameters corresponding to the design disciplines.

(1) AA discipline

An optimization model of the AA discipline is

$$\min \quad J_1\left(\boldsymbol{X}_1\right) = \left(i - i^*\right)^2 + \left(E - E^*\right)^2 + \left(\sigma - \sigma^*\right)^2$$
$$\text{s.t.} \quad \boldsymbol{g}_{\text{cover}} \le \rho\theta_b, \ 0 \le i \le i_{\max};$$
$$\lambda_m \le \lambda_{a0}, \lambda_a \le \lambda_n;$$
$$\delta_m \le \delta_{a0}, \delta_a \le \delta_n;$$
$$E \le E_0, \sigma \le \sigma_0$$
$$\text{D.V.} \quad \boldsymbol{X}_{AA} = \left\{\lambda_{a0}, \delta_{a0}, \lambda_a, \delta_a\right\} \qquad (24)$$

where $\boldsymbol{X}_1 = [i, E, \sigma]^T$ are global design variables of the AA discipline, $i$ is a shared design variable for the AA discipline and the propulsion discipline, $E$, $\sigma$ are state variables of the AA discipline directly related to the system level object; $\boldsymbol{X}_{AA} = [\lambda_{a0}, \delta_{a0}, \lambda_a, \delta_a]^T$ are local design variables of the AA discipline; $\boldsymbol{g}_{\text{cover}} = [\boldsymbol{g}_1, \boldsymbol{g}_2, \boldsymbol{g}_3]^T$ respectively represent coverage constraints of the satellite in three typical position conditions of the stationary position $\lambda_{s0}$, west error limit $\lambda_{s0}$ - $\Delta\lambda_{\max}$ and east error limit $\lambda_{s0}$ + $\Delta\lambda_{\max}$, where the satellite is in an orbit with small inclination, and coverage determination indexes corresponding to the coverage constraints are represented by $\Delta\gamma_1^-$, $\Delta\gamma_2^-$, $\Delta\gamma_3^-$, $\Delta\gamma_1^+$, $\Delta\gamma_2^+$ and $\Delta\gamma_3^+$ respectively; $\rho$ is a safety factor (which is set as 1), and $\theta_b$ represents half-width of the angle of the sub-beam (which is set as 0.3 degree).

The AA discipline calculation model includes analysis models of three design disciplines which are orbit, payload, and control. Corresponding variables and values listed in table 1.

Table 1 variables and values of the variables related to the AA discipline

| Variable name | Description of variable | Initial value | Lower limit | Upper limit | description |
|---|---|---|---|---|---|
| $\delta_{a0}$ | latitude of the nominal pointing direction of the central boresight of the antenna | 29.6 degree | 25 degree | 35 degree | input |
| $\delta_a$ | latitude of the dynamic pointing direction of the central boresight of the antenna | 29.6 degree | 25 degree | 35 degree | input |
| $\lambda_{a0}$ | longitude of the nominal pointing direction of the central boresight of the antenna | 103.9 degree | 95 degree | 115 degree | input |

(continued)

| Variable name | Description of variable | Initial value | Lower limit | Upper limit | description |
|---|---|---|---|---|---|
| $\lambda_a$ | longitude of the dynamic pointing direction of the central boresight of the antenna | 103.9 degree | 95 degree | 115 degree | input |
| $i$ | orbit inclination angle | 5 degree | 0 degree | 7.5 degree | Input(shared design variable) |
| $E$ | coverage evaluation index | - | 0 degree | 0.3 degree | output |
| $\sigma$ | coverage evaluation index | - | 0 degree | 0.3 degree | output |
| $\Delta\gamma_1^-$ | coverage determination index | - | 0 degree | 0.3 degree | output |
| $\Delta\gamma_2^-$ | coverage determination index | - | 0 degree | 0.3 degree | output |
| $\Delta\gamma_3^-$ | coverage determination index | - | 0 degree | 0.3 degree | output |
| $\Delta\gamma_1^+$ | coverage determination index | - | 0 degree | 0.3 degree | output |
| $\Delta\gamma_2^+$ | coverage determination index | - | 0 degree | 0.3 degree | output |
| $\Delta\gamma_3^+$ | coverage determination index | - | 0 degree | 0.3 degree | output |

(2) structure discipline

An optimization model of the structure design discipline is

$$\min \ J_2\left(X_2\right)=\left(m_{fuel}-m_{fuel}^*\right)^2$$
$$\text{s.t.} \quad f_x, f_y \geq f_h$$
$$f_z \geq f_v$$
$$\text{D.V.} \ \ X_{struc} \tag{25},$$

where $X_2=[m_{fuel}]^T$ is a global design variable of the structure discipline, $m_{fuel}$ is a coupled state variable between the structure discipline and the propulsion discipline; $X_{struc}$ is a local design variable of the propulsion discipline, and corresponds to parameters of structure dimension of the satellite; and $f_h$ and $f_v$ are first order horizontal constraint and longitudinal constraint of the fundamental frequency of the whole satellite respectively. The analysis model of the structure discipline and the calculation model for deployable masts of the antenna are used as a calculation model of the structure discipline, and variables corresponding thereto and values thereof are as shown in Figure 2.

Table 2 variables and values of the variables related to the structure discipline

| Variable name | Description of variable | Initial value | Lower limit | Upper limit | description |
|---|---|---|---|---|---|
| f11 | south and north panels | 0.025m | 0.016m | 0.03m | input |
| f21 | south and north separators | 0.025m | 0.016m | 0.03m | input |
| s31 | bearing cylinder | 0.01m | 0.01m | 0.03m | input |

(continued)

| Variable name | Description of variable | Initial value | Lower limit | Upper limit | description |
|---|---|---|---|---|---|
| t41 | east and west panels and | 0.0202m | 0.016m | 0.03m | input |
| t51 | east and west separators | 0.0202m | 0.016m | 0.03m | input |
| t61 | earth-facing panel | 0.025m | 0.016m | 0.03m | input |
| t71 | middle panel and panel facing away from the earth | 0.0202m | 0.016m | 0.03m | input |
| $m_{fuel}$ | weight of the thruster | 2935kg | 2700kg | 3100kg | input (coupled state variable) |
| m | weight of the whole satellite | - | - | - | output |
| fx | fundamental frequency of the whole satellite along x direction | - | 12Hz | - | output |
| fy | fundamental frequency of the whole satellite along y direction | - | 12Hz | - | output |
| fz | fundamental frequency of the whole satellite along z direction | - | 35Hz | - | output |
| $\alpha_1$ | installation azimuth angle of the big mast | 85.89 degree | 0 degree | 90 degree | input |
| $\beta_1$ | installation elevation angle of the big mast | 274.70 degree | 0 degree | 360 degree | input |
| $\alpha_2$ | installation azimuth angle of the small mast | 46.88 degree | 0 degree | 90 degree | input |
| $\beta_2$ | installation elevation angle of the small mast | 274.26 degree | 0 degree | 360 degree | input |
| $\Delta r$ | lateral eccentricity of the center of mass | 56.8mm | 0mm | 100mm | output |

(3) propulsion discipline

An optimization model of the propulsion discipline is

$$
\begin{aligned}
\min \quad & J_3\left(\boldsymbol{X}_3\right)=\left(i-i^*\right)^2+\left(L-L^*\right)^2+\left(m_{struc}-m_{struc}^*\right)^2 \\
\text{s.t.} \quad & \Delta r \leq \Delta r_0, dis\_ac \geq d_{ac0} \\
& \boldsymbol{M}_d \leq \boldsymbol{M}_0 \\
& m_{fuel} \leq m_{fuel0} \\
\text{D.V.} \quad & \boldsymbol{X}_{BB}=\left\{l_1,\alpha_1,\beta_1,l_2,\alpha_2,\beta_2,\boldsymbol{S}\right\}
\end{aligned}
\tag{26},
$$

where $\boldsymbol{X}_3=[i,L,m_{struc}]^T$ are global design variables, $i$ is a shared design variable between the propulsion discipline and the A discipline, $L$ is a state variable of the propulsion discipline which is directly related to the system object, $m_{struc}$ is a coupled state variable between the propulsion discipline and the structure discipline; $\boldsymbol{X}_{BB} = [l_1,\alpha_1, \beta_1,l_2, \alpha_2,\beta_2,\boldsymbol{S}]^T$ are local design variables of the propulsion discipline, $\boldsymbol{S}$ is a layout installation parameter of the thruster; and $\Delta r_0$ is a lateral eccentricity of the satellite with a deployed antenna, along Y axis and Z axis of the satellite system, $d_{ac0}$ is a requirement for a minimum distance of a deployed deployable mast of the antenna along X axis of the satellite system, $\boldsymbol{M}_0$ is upper limit of interference of attitude control, $m_{fuel}$ is propellant consumed in the life cycle, and $m_{fuel0}$ is propellant theoretically

carried.

Variables corresponding to the child discipline of propulsion and values thereof are as listed in table 3.

Table 3 variables values of the variables related to the propulsion discipline

| Variable name | Description of variable | Initial value | Lower limit | Upper limit | Description |
|---|---|---|---|---|---|
| $x_{2A}$ | x component of a position of thruster 2A | -1.21m | -1.21m | -0.6m | input |
| $x_{3A}$ | x component of a position of thruster 3A | 0.84m | 0.6m | 1.21m | input |
| $x_{4A}$ | x component of a position of thruster 4A | -0.68m | -1.21m | 0.6m | input |
| $y_{2A}$ | y component of a position of thruster 2A | -0.95m | -0.95m | -0.65m | input |
| $\alpha_{2A}$ | installation azimuth angle of thruster 2A | -173.62degree | -180 degree | -90 degree | input |
| $\beta_{2A}$ | elevation angle of thruster 2A | 12.97degree | 0 degree | 90 degree | input |
| $\alpha_{3A}$ | installation azimuth angle of thruster 3A | 165.64 degree | 90 degree | 180 degree | input |
| $\beta_{3A}$ | elevation angle of thruster 3A | -30.01 degree | -90 degree | 0 degree | input |
| $\alpha_{4A}$ | installation azimuth angle of thruster 4A | -43.51 degree | -90 degree | -30 degree | input |
| $\beta_{4A}$ | elevation angle of thruster 4A | -55.01 degree | -90 degree | -30 degree | input |
| $\alpha_{5A}$ | installation azimuth angle of thruster 5A | 10.34 degree | 0 degree | 90 degree | input |
| $\beta_{5A}$ | elevation angle of thruster 5A | 21.99 degree | 0 degree | 90 degree | input |
| $i$ | orbit inclination angle | 3 degree | 3 degree | 6.5 degree | input(shared design variable) |
| $L$ | operating lifetime | 12 years | 10 years | 15 years | input (coupled state variable) |
| $m_{struc}$ | weight of the structure subsystem | 350kg | 300kg | 400kg | Input(coupled state variable) |
| $m_{fuel}$ | propellant actually consumed | 2935kg | 2700kg | 3100kg | output |

9. multidisciplinary collaborative optimizing and solving module

The collaborative optimizing and solving module performs iteration solving based on the parent discipline optimization models and the child discipline optimization models obtained by the two-level collaborative optimization module, and the approximation model obtained through regression or, interpolation and fitting, and transmitted by the model simplification module, and obtains an optimization result (design variables and optimization objects) through optimization, which is shown in table 4.

Table 4 multidisciplinary collaborative optimization result of parameters of an overall scheme of the mobile communication satellite

| serial number | description of variable | variable name | optimization result |
|---|---|---|---|
| 1 | latitude of the nominal pointing direction of the central boresight of the antenna | $\delta_{a0}$ | 34° |

(continued)

| serial number | description of variable | variable name | optimization result |
|---|---|---|---|
| 2 | latitude of the dynamic pointing direction of the central boresight of the antenna | $\delta_a$ | 34° |
| 3 | longitude of the nominal pointing direction of the central boresight of the antenna | $\lambda_{a0}$ | 110.7° |
| 4 | longitude of the dynamic pointing direction of the central boresight of the antenna | $\lambda_a$ | 110.7° |
| 5 | orbit inclination angle | $i$ | 6.5° |
| 6 | installation azimuth angle of the big mast | $\alpha_1$ | 85.89° |
| 7 | installation elevation angle of the big mast | $\beta_1$ | 274.70° |
| 8 | installation azimuth angle of the small mast | $\alpha_2$ | 46.88° |
| 9 | installation elevation angle of the small mast | $\beta_2$ | 274.26° |
| 10 | x component of a position of thruster 2A | $x_{2A}$ | -1.21m |
| 11 | x component of a position of thruster 3A | $x_{3A}$ | 0.84m |
| 12 | x component of a position of thruster 4A | $x_{4A}$ | -0.68m |
| 13 | y component of a position of thruster 2A | $y_{2A}$ | -0.95m |
| 14 | installation azimuth angle of thruster 2A | $\alpha_{2A}$ | -173.62° |
| 15 | elevation angle of thruster 2A | $\beta_{2A}$ | 12.97° |
| 16 | installation azimuth angle of thruster 3A | $\alpha_{3A}$ | 165.64° |
| 17 | elevation angle of thruster 3A | $\beta_{3A}$ | -30.01° |
| 18 | installation azimuth angle of thruster 4A | $\alpha_{4A}$ | -43.51° |
| 19 | elevation angle of thruster 4A | $\beta_{4A}$ | 0.131° |
| 20 | installation azimuth angle of thruster 5A | $\alpha_{5A}$ | 10.34° |
| 21 | elevation angle of thruster 5A | $\beta_{5A}$ | 21.99° |
| 22 | weight of the structure subsystem | $m_{struc}$ | 337kg |
| 23 | south and north panels | f11 | 0.016m |
| 24 | south and north separators | f21 | 0.016m |
| 25 | bearing cylinder | s31 | 0.01m |
| 26 | east and west panels and bracket | t41 | 0.016m |
| 27 | east and west separators | t51 | 0.016m |
| 28 | panel facing the earth | t61 | 0.016m |
| 29 | middle panel and panel facing away from the earth | t71 | 0.016m |
| 30 | weight of the thruster | $m_{fuel}$ | 2948kg |
| 31 | coverage evaluation index | $E$ | 0.131° |
| 32 | coverage evaluation index | $\sigma$ | 0.0004 |

10. satellite overall scheme parameter outputting module

The optimized design variables are extracted according to the result of the multidisciplinary collaborative design optimization solving, and parameters and a report of the overall scheme of the mobile communication satellite are automatically generated.

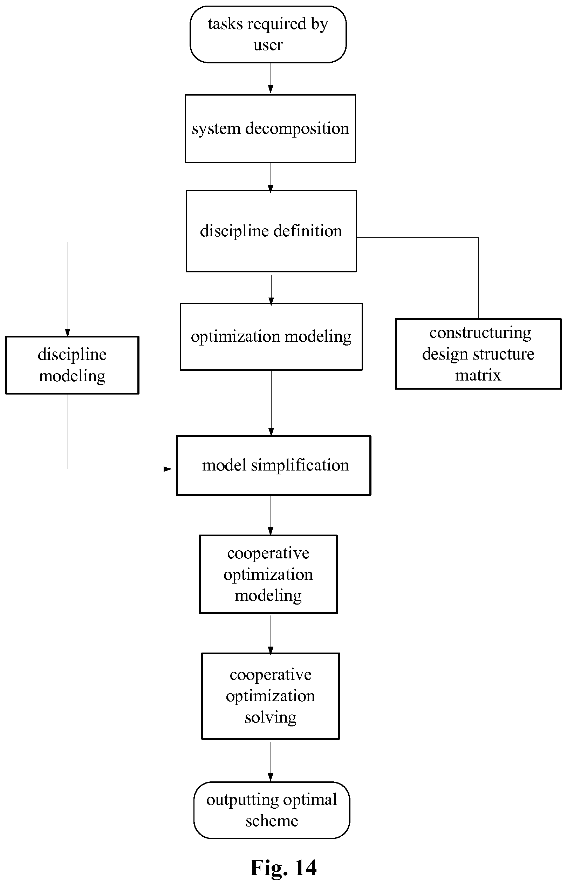

Figure 14 illustrates method for implementing the system for determining a satellite overall scheme. The method includes following steps.

(1) forming an overall technical index set by parameterizing functional indexes and non-functional indexes of a satellite system;

(2) determining technical requirements of subsystems of the satellite according to the overall technical index set formed in step (1), decomposing a satellite overall design plan into design disciplines according to technical requirements of subsystems of the satellite, determining calculation tasks of each design discipline according to the overall technical index set, and determining input parameters and output parameters for each design discipline;

(3) generating a satellite overall design structure matrix based on the decomposed design disciplines in step (2); wherein the generating a design structure matrix comprises: performing intersection calculation on the input parameters and output parameters of the design disciplines, generating a design discipline correlation matrix table according to a result of the intersection calculation performed on the input parameters and output parameters of the design disciplines, and generating a design discipline structure matrix; wherein the intersection calculation performed on the input parameters and output parameters of design disciplines comprises intersection calculation performed on input parameter sets, and intersection calculation performed on input parameter sets and output parameter sets, intersections of input parameter sets are shared design variables, and intersections of input parameter sets and output parameter sets are coupled state variables.

(4) establishing functional indexes and non-functional indexes of the satellite system, and calculation models corresponding to each subsystem of the satellite, based on the decomposed satellite design disciplines obtained in step (2) and the input parameters and output parameters;

(5) determining system technical indexes most concerned in the satellite overall technical index database as optimization objects; determining output parameters corresponding to the satellite system design boundary conditions as constraint variables; determining input disciplines and parameters corresponding to the optimization objects from the design parameter library; selecting, according to baseline type design parameters, variable input parameters from the input parameters as design variables; determining design disciplines to be optimized according to the optimization objects, the constraint variables and the design variables; and obtaining an intersection of the design structure matrix obtained in step (3) and the design disciplines to be optimized, as a satellite overall optimization-oriented design structure matrix;

(6) calculating sensitivity coefficients of the optimization objects and the constraint variables with respect to the design variables obtained in step (5) according to system global sensitivity equations, removing design variables with sensitivity coefficients smaller than or equal to a determined value; establishing regression or interpolation fitting models of reserved design variables and the output parameters of the optimization design disciplines corresponding to the regression or interpolation fitting models according to an experimental design method and an approximation model method to simplify the discipline calculation models in step (4); decoupling disciplines with sensitivity coefficients smaller than the determined value in the optimization design structure matrix, and uniting design disciplines in a serial relation in the optimization design structure matrix, to simplify the optimization design structure matrix obtained in step (5);

(7) decomposing the design disciplines in the optimization design structure matrix simplified in step (6) into parent disciplines and child disciplines; decoupling the parent disciplines from the child disciplines and decoupling the child disciplines according to consistency constraint equations between the disciplines at the two levels, wherein the consistency constraint equations are constructed by shared design variables and coupled state variables; allocating the constraint variables and design variables obtained in step (5) to the parent disciplines and the child disciplines; establishing parent discipline optimization models according to parent discipline optimization objects, constraint variables corresponding to the consistency constraint equations, and the parent discipline design variables constructed by shared design variables and coupled state variables, taking the parent consistency constraints as child discipline optimization objects and establishing child discipline optimization models based on child discipline optimization objects, child discipline constraint variables, and the child discipline design variables; wherein the parent disciplines are disciplines in least correlation with other disciplines, and the child disciplines are disciplines other than the parent disciplines in the optimization structure matrix;

(8) obtaining optimization results by performing iteration solving on the parent optimization models and the child optimization models obtained in step (7), the simplified models of the design disciplines obtained in step (6), and the not simplified models of the design disciplines obtained in step (4); and

(9) reporting an overall scheme generated from a satellite overall design scheme parameter set based on the optimization results output by step (8).

According to the disclosure, modules of the satellite system are general and applicable to determine overall schemes of various spacecrafts, except that the design discipline analysis, optimizing and modeling are related to engineering objects and thus are particular. For example, the other modules can be applied to low-orbit communication satellites, high-orbit communication satellites, and concept design and scheme design of constellation systems. As to different objects, the design disciplines are decomposed in a similar way, and design disciplines corresponding to particularity of the object are added in, a system optimization object, constraint variables and design variables are defined according to a goal of the scheme design for the object, and research content and input parameters and output parameters of the design disciplines are updated. For example, for a high-orbit communication satellite, system indexes such as coverage, weight and lifetime are generally selected as the optimization objects. For a low-orbit satellite, performance indexes such as coverage, revisit period are generally selected as the system optimization objects. And for the constellation system, system indexes such as number of satellites and costs are used as the system optimization objects.

Solutions according to the embodiments of the disclosure are successfully applied to an overall design of a GEO mobile communication satellite and achieve multidisciplinary optimization of overall parameters of the GEO spacecraft. And the solutions are applied to designs of overall schemes of multiple business satellite schemes, and win multiple business contracts. Presently, applicable in design for a new satellite platform, and feasibility thereof are to be researched.

The technology not described in great detail in this disclosure is known in this art.

## Claims

1. A system for determining a satellite overall scheme based on multidisciplinary optimization comprising: a satellite design parameter input system, a FPGA system, a central database storage and management system, and a satellite scheme parameter outputting module; wherein the satellite design parameter input system comprises a satellite overall technical index extracting module, and a satellite overall technical index allocating module; the FPGA system comprises a satellite subsystem technical index forming module, a satellite system design discipline decomposing module, a design structure matrix generating module, a satellite system discipline analyzing and modeling module, a satellite system optimizing and modeling module, a model simplification module, a two-level collaborative optimizing and modeling module, and a collaborative optimizing and solving module; wherein the central database storage and management system comprises a satellite overall technology index database, a model baseline design database, a design parameter base, and a model library; and the central database storage and management system comprises a satellite overall technical index database, a model baseline design database, a design parameter library, and a model library;

   wherein the satellite overall technical index extracting module is configured to form an overall technical index set by parameterizing functional indexes and non-functional indexes of a satellite system as required, and store the overall technical index set into the satellite overall technical index database; wherein the functional indexes are technical indexes indicating system performances of the satellite, and the non-functional indexes are supplementary technical indexes other than the functional indexes of the satellite;

   the satellite overall technical index allocating module is configured to allocate the overall technical index set in the satellite overall technical index database as input for the modules in the FPGA system;

   the satellite subsystem technical index forming module is configured to receive the overall technical index set transmitted by the satellite overall technical index allocating module, determine technical requirements of subsystems of the satellite according to the overall technical index set, and transmit the technical requirements to the satellite system design discipline decomposing module;

   the satellite system design discipline decomposing module is configured to decompose a satellite overall design plan into design disciplines according to the overall technical index set transmitted by the satellite overall technical index allocating module, determine calculation tasks of each design discipline, determine input parameters and output parameters for each design discipline, and store the input parameters and output parameters for each design discipline into the design parameter library respectively; where the design disciplines are calculation modules for performing functions of the subsystems or for analyzing system performances;

   the design structure matrix generating module is configured to generate a satellite overall design structure matrix based on the decomposed design disciplines in the design parameter library and the input parameters and output parameters, and transmit the design structure matrix to the satellite system optimizing and modeling module; wherein the generating a design structure matrix comprises: performing intersection calculation on the input parameters and output parameters of the design disciplines, generating a design discipline correlation matrix table according to a result of the intersection calculation performed on the input parameters and output parameters of the design disciplines, and generating a design discipline structure matrix;

the satellite system optimizing and modeling module is configured to determine system technical indexes most concerned in the satellite overall technical index database as optimization objects, determine output parameters corresponding to the satellite system design boundary conditions as constraint variables, acquire input parameters corresponding to the optimization objects from the design parameter library, in conjunction with design parameters provided by the model baseline design database, select variable input parameters from the input parameters as design variables, determine design disciplines to be optimized according to the optimization objects, the constraint variables and the design variables, obtain an intersection of the design structure matrix and the design disciplines to be optimized, as a satellite overall optimization-oriented design structure matrix, and transmit the satellite overall optimization-oriented design structure matrix to the model simplification module; wherein the determining design disciplines to be optimized comprises: obtaining an intersection of the optimization objects, the constraint variables and the design variables, as the design disciplines to be optimized;

the satellite system discipline analyzing and modeling module is configured to establish calculation models corresponding to the index requirements of each subsystem of the satellite according to the decomposed satellite design disciplines and the input parameters and output parameters stored in the design parameter library, transmit calculation models of the design disciplines to be simplified to the model simplification module, and directly store analysis models of the design disciplines not to be simplified to the model library;

the model simplification module is configured to calculate sensitivity coefficients of the optimization objects and the constraint variables with respect to the design variables according to satellite system global sensitivity equations or system sensitivity analysis, remove design variables with sensitivity coefficients smaller than or equal to a determined value, establish regression or interpolation fitting models of reserved design variables and the output parameters of the optimization design disciplines corresponding to the regression or interpolation fitting models according to an experimental design method and an approximation model method to simplify the discipline calculation models transmitted by the satellite system discipline analyzing and modeling module, store the simplified regression or interpolation fitting models of the design disciplines into the model library, and name the regression or interpolation fitting models as approximation models; decouple design disciplines with sensitivity coefficients smaller than the determined value in the optimization design structure matrix, and unite design disciplines in a serial relation in the optimization design structure matrix, to simplify the optimization design structure matrix;

the two-level collaborative optimizing and modeling module is configured to decompose the design disciplines in the simplified optimization design structure matrix output by the model simplification module into parent disciplines and child disciplines, decouple the parent disciplines from the child disciplines and decouple the child disciplines according to consistency constraint equations between the disciplines at the two levels, wherein the consistency constraint equations are constructed by shared design variables and coupled state variables, allocate the constraint variables and design variables output by the satellite optimizing and modeling module to the parent disciplines and the child disciplines, establish parent discipline optimization models according to parent discipline optimization objects, constraint variables corresponding to the consistency constraint equations, and the parent discipline design variables constructed by shared design variables and coupled state variables, take the parent consistency constraints as child discipline optimization objects and establish child discipline optimization models based on child discipline optimization objects, child discipline constraint variables, and the child discipline design variables; wherein the parent disciplines are disciplines in least correlation with other disciplines, and the child disciplines are disciplines other than the parent disciplines in the optimization structure matrix;

the collaborative optimizing and solving module is configured to obtain optimized design variables by performing iteration solving on the parent optimization models and the child optimization models obtained by the two-level collaborative optimizing and modeling module, and the calculation models of the design disciplines in the model library;

the satellite scheme parameter outputting module is configured to report an overall scheme generated from a satellite overall design scheme parameter set based on the optimized result output by the collaborative optimizing and solving module;

the satellite overall technical index database is configured to store the overall technical index set output by the satellite overall technical index extracting module;

the model baseline design database is configured to store design parameters of an existing historical type satellite, and provide the design parameters of the existing historical type satellite to the satellite system optimizing and modeling module to determine optimization design variables;

the design parameter library is configured to store the design disciplines decomposed by the satellite system design discipline decomposing module; and
the module library is configured to store the design discipline calculation models established by the satellite system discipline analyzing and modeling module, and the design discipline approximation models simplified and output by the model simplification module.

2. The system for determining a satellite overall scheme based on multidisciplinary optimization according to claim 1, wherein the technical indexes indicating system performances comprise at least: coverage, direction, and communication capacity, wherein the supplementary technical indexes comprise at least: weight of the whole satellite, power, total heat consumption, outline envelop size, center of mass, basic structural frequency, lifetime, costs and reliability.

3. The system for determining a satellite overall scheme based on multidisciplinary optimization according to claim 1, wherein the design disciplines comprise at least models of payload, orbit, control, propulsion, structure, configuration, power supply, thermal control, data management, measurement and control, reliability, and costs.

4. The system for determining a satellite overall scheme based on multidisciplinary optimization according to claim 1, wherein the discipline correlation matrix table is generated by: defining generated input parameters and output parameters of each discipline as string vectors, performing an analysis of correlation between the design disciplines by performing intersection calculation on the string vectors, and automatically extracting a result of vector calculation, denoting the result as 1 if the result is not null, wherein is the 1 indicates there is a correlation, otherwise denoting the result as 0.

5. The system for determining a satellite overall scheme based on multidisciplinary optimization according to claim 1, wherein the intersection calculation performed on the input parameters and output parameters of design disciplines comprises intersection calculation performed on input parameter sets, and intersection calculation performed on input parameter sets and output parameter sets, intersections of input parameter sets are stored as shared design variables, and intersections of input parameter sets and output parameter sets are stored as coupled state variables.

6. The system for determining a satellite overall scheme based on multidisciplinary optimization according to claim 1, being applied in scheme design and optimization for a low earth orbit communication satellite, a high earth orbit communication satellite or a constellation system.

7. A method for implementing the system for determining a satellite overall scheme provided in claim 1, comprising:

    (1) forming an overall technical index set by parameterizing functional indexes and non-functional indexes of a satellite system;
    (2) determining technical requirements of subsystems of the satellite according to the overall technical index set formed in step (1), decomposing a satellite overall design plan into design disciplines according to technical requirements of subsystems of the satellite, determining calculation tasks of each design discipline according to the overall technical index set, and determining input parameters and output parameters for each design discipline;
    (3) generating a satellite overall design structure matrix based on the decomposed design disciplines in step (2); wherein the generating a design structure matrix comprises:

        performing intersection calculation on the input parameters and output parameters of the design disciplines, generating a design discipline correlation matrix table according to a result of the intersection calculation performed on the input parameters and output parameters of the design disciplines, and generating a design discipline structure matrix; wherein the intersection calculation performed on the input parameters and output parameters of design disciplines comprises intersection calculation performed on input parameter sets, and intersection calculation performed on input parameter sets and output parameter sets, intersections of input parameter sets are shared design variables, and intersections of input parameter sets and output parameter sets are coupled state variables.

    (4) establishing functional indexes and non-functional indexes of the satellite system, and calculation models corresponding to each subsystem of the satellite, based on the decomposed satellite design disciplines obtained in step (2) and the input parameters and output parameters;
    (5) determining system technical indexes most concerned in the satellite overall technical index database as optimization objects; determining output parameters corresponding to the satellite system design boundary conditions as constraint variables; determining input disciplines and parameters corresponding to the optimization objects from the design parameter library; selecting, according to baseline type design parameters, variable input parameters from the input parameters as design variables; determining design disciplines to be optimized according to the optimization objects, the constraint variables and the design variables; and obtaining an intersection of the design structure matrix obtained in step (3) and the design disciplines to be optimized, as a satellite overall optimization-oriented design structure matrix;

(6) calculating sensitivity coefficients of the optimization objects and the constraint variables with respect to the design variables obtained in step (5) according to system global sensitivity equations, removing design variables with sensitivity coefficients smaller than or equal to a determined value; establishing regression or interpolation fitting models of reserved design variables and the output parameters of the optimization design disciplines corresponding to the regression or interpolation fitting models according to an experimental design method and an approximation model method to simplify the discipline calculation models in step (4); decoupling disciplines with sensitivity coefficients smaller than the determined value in the optimization design structure matrix, and uniting design disciplines in a serial relation in the optimization design structure matrix, to simplify the optimization design structure matrix obtained in step (5);

(7) decomposing the design disciplines in the optimization design structure matrix simplified in step (6) into parent disciplines and child disciplines; decoupling the parent disciplines from the child disciplines and decoupling the child disciplines according to consistency constraint equations between the disciplines at the two levels, wherein the consistency constraint equations are constructed by shared design variables and coupled state variables; allocating the constraint variables and design variables obtained in step (5) to the parent disciplines and the child disciplines; establishing parent discipline optimization models according to parent discipline optimization objects, constraint variables corresponding to the consistency constraint equations, and the parent discipline design variables constructed by shared design variables and coupled state variables, taking the parent consistency constraints as child discipline optimization objects and establishing child discipline optimization models based on child discipline optimization objects, child discipline constraint variables, and the child discipline design variables; wherein the parent disciplines are disciplines in least correlation with other disciplines, and the child disciplines are disciplines other than the parent disciplines in the optimization structure matrix;

(8) obtaining optimization results by performing iteration solving on the parent optimization models and the child optimization models obtained in step (7), the simplified models of the design disciplines obtained in step (6), and the not simplified models of the design disciplines obtained in step (4); and

(9) reporting an overall scheme generated from a satellite overall design scheme parameter set based on the optimization results output by step (8).

8. The method for implementing the system for determining a satellite overall scheme according to claim 7, being applied in scheme design and optimization for a low earth orbit communication satellite, a high earth orbit communication satellite or a constellation system.

**Fig .1**

**Fig. 2**

**Fig. 3**

**Fig. 4**

**Fig. 5**

**Fig. 6**

**Fig. 7**

**Fig. 8**

**Fig. 9**

boundary of sub-beam

external side of beam

$A_j\left(\lambda_{b,j},\delta_{b,j}\right)$

$C\left(\lambda_{cj},\delta_{cj}\right)$

$M$

$p_{j+1}$

$p_j\left(\lambda_{sb,j},\delta_{sb,j}\right)$

$p_{j-1}$

internal side of beam

$N$

$D\left(\lambda_{dj},\delta_{dj}\right)$

$p_j$

$A_j$

$\overrightarrow{SA}_j$

$\overrightarrow{SP}_j$

$\Delta\gamma_j$

$S\left(\lambda_s,\delta_s\right)$

**Fig. 10**

AA

structure

propulsion

coverage

lifetime

**Fig. 11**

proxy model

optimizer

**Fig. 12**

disciplines of system performance

$$\max\quad L;\ \min\quad \sigma,\ E$$
$$s.t.\quad J_i \le \varepsilon \quad (i=1,\cdots,3)$$
$$X^* = \left[ X_1^*, X_2^*, X_3^* \right]$$

$J_1$　　$\mathbf{X}_1^*$　　　$J_2$　$\mathbf{X}_2^*$　　　$\mathbf{X}_3^*$　$J_3$

AA discipline

$Min\ J_1$

$D.V.\ \boldsymbol{X}_{AA}$

structure discipline

$Min\ J_2$

$D.V.\ \boldsymbol{X}_{struc}$

propulsion discipline

$Min\ J_3$

$D.V.\ \boldsymbol{S}$

analysis model
of orbit,
payload and
control design
discipline

approximation
model of
structure
design
discipline

analysis model
of propulsion
design
discipline

**Fig. 13**

tasks required by user

↓

system decomposition

↓

discipline definition

discipline modeling

optimization modeling

constructuring design structure matrix

↓

model simplification

↓

cooperative optimization modeling

↓

cooperative optimization solving

↓

outputting optimal scheme

**Fig. 14**

# INTERNATIONAL SEARCH REPORT

International application No.

**PCT/CN2014/079075**

### A. CLASSIFICATION OF SUBJECT MATTER

G06F 17/50 (2006.01) i

According to International Patent Classification (IPC) or to both national classification and IPC

### B. FIELDS SEARCHED

Minimum documentation searched (classification system followed by classification symbols)

G06F 17, H04Q 7

Documentation searched other than minimum documentation to the extent that such documents are included in the fields searched

Electronic data base consulted during the international search (name of data base and, where practicable, search terms used)

CNTXT; CNABS: multidisciplinary, satellite, aerocraft, subject, model, matrix, optimize, parameter

### C. DOCUMENTS CONSIDERED TO BE RELEVANT

| Category* | Citation of document, with indication, where appropriate, of the relevant passages | Relevant to claim No. |
|---|---|---|
| A | CN 103761377 A (BEIJING UNIVERSITY OF AERONAUTICS AND ASTRONAUTICS), 30 April 2014 (30.04.2014), description, paragraphs [0134]-[0147] | 1-8 |
| A | CN 102004827 A (DALIAN UNIVERSITY OF TECHNOLOGY), 06 April 2011 (06.04.2011), the whole document | 1-8 |
| A | CN 101995825 A (DALIAN UNIVERSITY OF TECHNOLOGY), 30 March 2011 (30.03.2011), the whole document | 1-8 |

☐ Further documents are listed in the continuation of Box C.  ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12 January 2015 (12.01.2015) | **17 February 2015 (17.02.2015)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **DUAN, Wei** Telephone No.: (86-10) **62412036** |

Form PCT/ISA/210 (second sheet) (July 2009)

## INTERNATIONAL SEARCH REPORT
### Information on patent family members

| International application No. |
| --- |
| **PCT/CN2014/079075** |

| Patent Documents referred in the Report | Publication Date | Patent Family | Publication Date |
| --- | --- | --- | --- |
| CN 103761377 A | 30 April 2014 | None | |
| CN 102004827 A | 06 April 2011 | None | |
| CN 101995825 A | 30 March 2011 | CN 101995825 B | 18 July 2012 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201410228903